# EUROPEAN PATENT APPLICATION

(11) **EP 4 734 323 A1**
(43) Date of publication of application: **29.04.2026**
(21) Application number: 24855255.6
(22) Date of filing: 13.03.2024
(51) Int. Cl.: H02J 7/00

(54) **POWER SUPPLY CIRCUIT AND RELATED APPARATUS**

(30) Priority: 18.08.2023 CN 202311052405
(71) Applicant: Honor Device Co., Ltd., Shenzhen, Guangdong 518040 (CN)
(72) Inventor: WANG, Xing, Shenzhen, Guangdong 518040 (CN); TANG, Ruichao, Shenzhen, Guangdong 518040 (CN)
(74) Representative: Isarpatent
(86) International application number: PCT/CN2024/081523
(87) International publication number: WO 2025/039524

(57) **Abstract**

Embodiments of this application provide a power supply circuit and a related apparatus, used in the field of terminal technologies. The power supply circuit includes: an EIS module connected to a battery, a controller, and a power management module. The EIS module is connected to the controller, and the controller is connected to the power management module. The EIS module may detect an internal resistance of the battery and transmit the internal resistance of the battery to the controller. The controller may obtain a charge cutoff voltage and/or a charge cutoff current of the battery according to the internal resistance of the battery, and send a first control signal to the power management module. The power management module may control the charge cutoff voltage and/or the charge cutoff current of the battery according to the first control signal. In this way, a charging policy of the battery is adjusted by using the internal resistance of the battery that is detected by the EIS module. Based on the internal resistance of the battery, an aging degree of the battery is represented and adjusted, to reduce a case in which the charging policy does not match the aging degree of the battery, so as to reduce phenomena such as heat generation, bulging, and insufficient charging of the battery, and improve safety of the battery.

## Description

This application claims priority to Chinese Patent Application No. 202311052405.5, filed with China National Intellectual Property Administration on August 18, 2023 and entitled "POWER SUPPLY CIRCUIT AND RELATED APPARATUS", which is incorporated herein by reference in its entirety.

### TECHNICAL FIELD

This application relates to the field of terminal technologies, and in particular, to a power supply circuit and a related apparatus.

### BACKGROUND

With the development and progress of society, terminal devices such as a mobile phone and a tablet computer have become an indispensable part of people's life. A terminal device is usually equipped with a battery, to facilitate use by a user.

However, after the terminal device is used for a long time, a phenomenon such as insufficient charging of the battery for a long time, overheat of the battery, or bulging of the battery may occur, and safety of the battery is low.

### SUMMARY

Embodiments of this application provide a power supply circuit and a related apparatus, used in the field of terminal technologies. An internal resistance of a battery is detected through an EIS module, and a charging policy of the battery is adjusted based on the internal resistance of the battery. Based on the internal resistance of the battery, an aging degree of the battery is represented and adjusted, to reduce a case in which the charging policy does not match the aging degree of the battery, so as to reduce phenomena such as heat generation, bulging, and insufficient charging of the battery, and improve safety of the battery.

According to a first aspect, an embodiment of this application provides a power supply circuit. The power supply circuit includes: an EIS module, a controller, and a power management module. The EIS module is connected to the controller, the controller is connected to the power management module, and the EIS module is further connected to a battery.

The EIS module may detect an internal resistance of the battery and transmit the internal resistance of the battery to the controller. The controller may obtain a charge cutoff voltage and/or a charge cutoff current of the battery according to the internal resistance of the battery, and send a first control signal to the power management module. The first control signal includes the charge cutoff voltage and/or the charge cutoff current. The power management module may control the charge cutoff voltage and/or the charge cutoff current of the battery according to the first control signal.

In this way, based on the internal resistance of the battery, an aging degree of the battery is represented and adjusted, to reduce a case in which a charging policy does not match the aging degree of the battery, so as to reduce phenomena such as heat generation, bulging, and insufficient charging of the battery, and improve safety of the battery. Optionally, the EIS module includes: a detection unit and a control unit. An input end of the detection unit is connected to a first end of the control unit, and an output end of the detection unit is connected to a second end of the control unit. The control unit may control, through the first end, the detection unit to output a plurality of disturbance signals to the battery, where frequencies of the plurality of disturbance signals are different. The detection unit detects a plurality of voltage signals output by the battery under the plurality of disturbance signals, and converts the plurality of voltage signals into a plurality of digital signals. The detection unit transmits the plurality of digital signals to the control unit through the second end. After obtaining the plurality of digital signals, the control unit obtains the internal resistance of the battery based on the plurality of digital signals.

In this way, the EIS module may apply disturbance signals of different frequencies to the battery and obtain, through measurement, voltage changes of the battery under the disturbance signals, to obtain impedances of the battery at different frequencies, so as to obtain the internal resistance of the battery.

Optionally, the disturbance signal includes: a square wave or a quasi-square wave.

In this way, an implementation of a square wave signal or a quasi-square wave signal is simple and the square wave signal or the quasi-square wave signal is easy to obtain.

Optionally, the detection unit includes: a first resistor, a switch tube Q1, a first differential amplifier, and an analog to digital converter. One end of the first resistor is connected to a positive electrode of the battery, the other end of the first resistor is connected to a first electrode of the switch tube Q1, and a second electrode of the switch tube Q1 is grounded. A first input end of the first differential amplifier is connected to the positive electrode of the battery, a second input end of the first differential amplifier is connected to a negative electrode of the battery, and an output end of the first differential amplifier is connected to an input end of the analog to digital converter. The input end of the detection unit is a control electrode of the switch tube Q1. The output end of the detection unit is an output end of the analog to digital converter.

The control unit may control, through the first end, the switch tube Q1 to be turned on or turned off, to control the detection unit to output the plurality of disturbance signals to the battery. The first differential amplifier of the detection unit may amplify a difference between a voltage at the positive electrode of the battery and a voltage at the negative electrode of the battery based on a first amplification coefficient. The analog to digital converter may convert a plurality of voltage signals output by the first differential amplifier into the plurality of digital signals and transmit the plurality of digital signals to the control unit. After obtaining the plurality of digital signals, the control unit obtains the internal resistance of the battery based on the plurality of digital signals.

In this way, through on or off of the switch tube Q1, the detection unit outputs the disturbance signals to the battery. This manner is simple and easy to implement. Moreover, the switch tube has a relatively small size and low costs.

Optionally, the control unit may control, through the first end, the switch tube Q1 to be turned on or turned off according to a duty cycle of 50%.

In this way, when the duty cycle has a value of 50%, subsequent calculation may be facilitated, and calculation difficulty is reduced.

Optionally, the control unit may perform Fourier transform on the plurality of digital signals, to obtain voltage values corresponding to a plurality of frequencies. The control unit may calculate voltage values corresponding to the plurality of frequencies and a value of a current flowing through the first resistor, to obtain impedances of the battery at the plurality of frequencies. The control unit may perform fitting processing on the impedances of the battery at the plurality of frequencies, to obtain the internal resistance of the battery.

**In** this way, the control unit may obtain the internal resistance of the battery according to the plurality of digital signals.

Optionally, the detection unit further includes: a constant current source. The constant current source is connected between the first resistor and the battery, or the constant current source is connected between the first resistor and the switch tube Q1. The constant current source may stabilize the current flowing through the first resistor.

**In** this way, a current output by the battery is stable, so that a test error caused by an unstable current can be reduced, precision of an EIS test can be improved, and accuracy of the internal resistance of the battery can be improved.

Optionally, the constant current source includes: a second differential amplifier, a second resistor, and a switch tube Q2. The constant current source is connected between the first resistor and the battery, a first electrode of the switch tube Q2 is connected to the positive electrode of the battery, a second electrode of the switch tube Q2 is connected to one end of the first resistor, a control electrode of the switch tube Q2 is connected to an output end of the second differential amplifier, and a first input end of the second differential amplifier may input a first reference voltage; and a second input end of the second differential amplifier is connected to the other end of the second resistor, and one end of the second resistor is connected to the second electrode of the switch tube Q2.

Alternatively, the constant current source is connected between the first resistor and the switch tube Q1, a first electrode of the switch tube Q2 is connected to the other end of the first resistor, a second electrode of the switch tube Q2 is connected to the first electrode of the switch tube Q1, a control electrode of the switch tube Q2 is connected to an output end of the second differential amplifier, and a first input end of the second differential amplifier may input a first reference voltage; and a second input end of the second differential amplifier is connected to the other end of the second resistor, and one end of the second resistor is connected to the second electrode of the switch tube Q2.

The second differential amplifier may adjust a voltage at the control electrode of the switch tube Q2 based on a voltage at the other end of the second resistor and the first reference voltage, to stabilize a voltage at one end of the second resistor.

In this way, the second differential amplifier collects voltages at the second resistor in real time, and adjusts a resistance of Q2 based on the voltages at the second resistor and the first reference voltage, so that a current flowing through the first resistor keeps stable.

Optionally, the constant current source includes: a switch tube Q3, a third differential amplifier, a third resistor, a fourth differential amplifier, and a fourth resistor. When the constant current source is located between the first resistor and the battery, a first electrode of the switch tube Q3 is connected to the positive electrode of the battery, a second electrode of the switch tube Q3 is connected to one end of the third resistor, and a control electrode of the switch tube Q3 is connected to an output end of the third differential amplifier; the other end of the third resistor is connected to one end of the first resistor; a first input end of the third differential amplifier may input a second reference voltage; a second input end of the third differential amplifier is connected to one end of the fourth resistor; the other end of the fourth resistor is connected to an output end of the fourth differential amplifier; and one end of the third resistor is connected to a first input end of the fourth differential amplifier, and the other end of the third resistor is connected to a second input end of the fourth differential amplifier.

Alternatively, when the constant current source is located between the first resistor and the switch tube Q1, a first electrode of the switch tube Q3 is connected to the other end of the first resistor, a second electrode of the switch tube Q3 is connected to one end of the third resistor, and a control electrode of the switch tube Q3 is connected to an output end of the third differential amplifier; the other end of the third resistor is connected to the first electrode of the switch tube Q1; a first input end of the third differential amplifier may input a second reference voltage; a second input end of the third differential amplifier is connected to one end of the fourth resistor; the other end of the fourth resistor is connected to an output end of the fourth differential amplifier; and one end of the third resistor is connected to a first input end of the fourth differential amplifier, and the other end of the third resistor is connected to a second input end of the fourth differential amplifier.

The fourth differential amplifier may output a voltage based on a voltage difference between two ends of the third resistor, where the voltage output by the fourth differential amplifier is directly proportional to the voltage difference between the two ends of the third resistor. The third differential amplifier may adjust a voltage at the control electrode of the switch tube Q3 based on the second reference voltage and a voltage at one end of the fourth resistor, to stabilize the voltage difference between the two ends of the third resistor.

In this way, voltages at the two ends of the third resistor may be collected, and feedback adjustment is performed on a resistance of the switch tube Q3 based on a voltage difference between the two ends of the third resistor, so that a current flowing through the first resistor keeps stable. In addition, a resistance of the third resistor is fixed, and that feedback adjustment is performed based on the voltage difference between the two ends of the third resistor may be understood as that feedback adjustment is performed based on a current flowing through the third resistor, so that the current flowing through the first resistor is stable, to improve accuracy of the internal resistance of the battery subsequently calculated based on the current flowing through the first resistor.

Optionally, the detection unit further includes: a capacitor C1 and/or a capacitor C2. One end of the capacitor C1 is connected to the positive electrode of the battery, and the other end of the capacitor C1 is connected to the first input end of the first differential amplifier. One end of the capacitor C2 is connected to the negative electrode of the battery, and the other end of the capacitor C1 is connected to the second input end of the first differential amplifier. The capacitor C1 may filter out a direct current component of a voltage input to the first input end of the first differential amplifier. The capacitor C2 may filter out a direct current component of a voltage input to the second input end of the first differential amplifier.

In this way, the capacitor C1 can filter out a direct current voltage signal input to the first differential amplifier. The capacitor C2 may filter out a direct current voltage signal input to the first differential amplifier, to reduce interference of the direct current voltage signal to an alternate current voltage signal, and improve test accuracy.

Optionally, the detection unit further includes: a first switch unit and a fifth differential amplifier. A first input end of the first switch unit is connected to the output end of the first differential amplifier. A second input end of the first switch unit is connected to an output end of the fifth differential amplifier. An output end of the first switch unit is connected to the analog to digital converter. A first input end of the fifth differential amplifier is connected to the positive electrode of the battery, and a second input end of the fifth differential amplifier is connected to the negative electrode of the battery.

When a switching frequency of the switch tube Q1 is greater than a first value, the control unit may control the first input end of the first switch unit to be connected to the output end of the first switch unit, so that the first differential amplifier is connected to the analog to digital converter. The EIS module may collect, through a path including the capacitor C1 and the capacitor C2, a voltage signal output by the battery. When the switching frequency is relatively low, the EIS module filters out a direct current component through the capacitor C1 and the capacitor C2, to reduce interference of a direct current voltage signal, so that an alternate current voltage signal is more accurate, and accuracy of a test result is improved.

When the switching frequency of the switch tube Q1 is less than or equal to the first value, the control unit may control the second input end of the first switch unit to be connected to the output end of the first switch unit, so that the fifth differential amplifier is connected to the analog to digital converter. The EIS module may collect, through a path including no capacitor, the voltage signal output by the battery. When the switching frequency is relatively high, the EIS module does not filter out the direct current component, to reduce impact of the capacitor on the alternate current voltage signal, and improve test accuracy.

Optionally, the detection unit further includes: the first switch unit includes: a switch S1 and a switch S2. A first electrode of the switch S1 is connected to the output end of the first differential amplifier, a second electrode of the switch S1 is connected to the analog to digital converter, and a control electrode of the switch S1 is controlled by the control unit. A first electrode of the switch S2 is connected to the output end of the fifth differential amplifier, a second electrode of the switch S2 is connected to the analog to digital converter, and a control electrode of the switch S2 is controlled by the control unit.

When the switching frequency of the switch tube Q1 is greater than the first value, the control unit may control the switch S1 to be turned on and the switch S2 to be turned off, so that the first differential amplifier is connected to the analog to digital converter. When the switching frequency of the switch tube Q1 is less than or equal to the first value, the control unit may control the switch S1 to be turned off and the switch S2 to be turned on, so that the fifth differential amplifier is connected to the analog to digital converter.

In this way, two test paths of the EIS module are controlled through two switch tubes, so that a structure is simple and easy to implement.

Optionally, the controller may further obtain a discharge cutoff voltage and/or a discharge cutoff current of the battery based on the internal resistance of the battery, and send a second control signal to the power management module. The second control signal further includes the discharge cutoff voltage and/or the discharge cutoff current. The power management module may further control the discharge cutoff voltage and/or the discharge cutoff current of the battery according to the second control signal.

In this way, the power supply circuit may adjust a charging parameter of the battery based on an aging degree of the battery, to reduce an overcharging situation of the battery, reduce phenomena such as heat generation and bulging of the battery, and prolong a battery lifetime.

Optionally, the circuit further includes: an electricity meter. The electricity meter is connected to the controller. The electricity meter may detect a current of the battery, and transmit the current of the battery to the controller. When duration over which the current of the battery is less than a first threshold lasts for first duration, the controller may control the EIS module to detect the internal resistance of the battery.

In this way, when the battery has no load or a relatively small load and the battery is relatively stable, EIS detection is performed, to improve test accuracy.

Optionally, the electricity meter includes: a fifth resistor and a sixth differential amplifier. The circuit further includes: a second switch unit. The EIS module includes: a first differential amplifier and an analog to digital converter. One end of the fifth resistor is connected to the negative electrode of the battery, the other end of the fifth resistor is grounded, a first input end of the sixth differential amplifier is connected to one end of the fifth resistor, a second input end of the sixth differential amplifier is connected to the other end of the fifth resistor, and an output end of the sixth differential amplifier is connected to a first input end of the second switch unit. A second input end of the second switch unit is connected to an output end of the first differential amplifier, and an output end of the second switch unit is connected to the analog to digital converter. The second switch unit is controlled by the controller. The electricity meter may obtain the current of the battery based on a voltage signal of the fifth resistor that is determined by the sixth differential amplifier and a resistance of the fifth resistor.

When the duration over which the current of the battery is less than the first threshold lasts for the first duration, the controller may control the first input end of the second switch unit to be connected to the output end of the second switch unit, so that the first differential amplifier is connected to the analog to digital converter. When the current of the battery is greater than or equal to the first threshold, the controller may further control the second input end of the second switch unit to be connected to the output end of the second switch unit, so that the sixth differential amplifier is connected to the analog to digital converter.

In this way, the electricity meter and the EIS module may reuse the analog to digital converter, to reduce costs of the power supply circuit.

Optionally, the circuit further includes: a first protection circuit, a second protection circuit, a first switch M1, a second switch M2, a third switch M3, and a fourth switch M4. A first detection end of the first protection circuit is connected to the positive electrode of the battery, a first control end of the first protection circuit is connected to a control end of the first switch M1, a second control end of the first protection circuit is connected to a control end of the second switch M2, a first detection end of the second protection circuit is connected to the positive electrode of the battery, a first control end of the second protection circuit is connected to a control end of the third switch M3, and a second control end of the second protection circuit is connected to a control end of the fourth switch M4.

One connection end of the first switch M1 is connected to the negative electrode of the battery, the other connection end of the first switch M1 is connected to one connection end of the second switch M2, the other connection end of the second switch M2 is connected to one connection end of the third switch M3, the other connection end of the third switch M3 is connected to one connection end of the fourth switch M4, and the other connection end of the fourth switch M4 is connected to the negative electrode of the battery.

When detecting that the battery has a phenomenon of overvoltage, undervoltage, and/or overcurrent, the first protection circuit may control the first switch M1 and/or the second switch M2 to be turned off, to disconnect the battery from a load. When detecting that the battery has the phenomenon of overvoltage, undervoltage, and/or overcurrent, the second protection circuit may control the third switch M3 and/or the fourth switch M4 to be turned off, to disconnect the battery from the load.

In this way, overvoltage, undervoltage, and/or overcurrent protection of the battery can be implemented, to improve safety of the battery. The two battery protection circuits may implement dual protection, to further improve the safety of the battery.

According to a second aspect, an embodiment of this application provides a chip. The chip includes the EIS module according to any implementation of the first aspect.

Optionally, the chip further includes one or more of the following modules: an electricity meter, a first protection circuit, and a second protection circuit.

According to a third aspect, an embodiment of this application provides a terminal device. The terminal device may also be referred to as a terminal (terminal), user equipment (user equipment, UE), a mobile station (mobile station, MS), a mobile terminal (mobile terminal, MT), or the like. The terminal device may be a mobile phone (mobile phone), a smart television, a wearable device, a tablet computer (Pad), a computer with a wireless transceiver function, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The terminal device includes the power supply circuit according to any implementation of the first aspect.

According to a fifth aspect, an embodiment of this application provides a computer-readable storage medium, and a computer program is stored in the computer-readable storage medium. When the computer program is executed by a processor, a method performed by the controller according to the first aspect is implemented.

According to a sixth aspect, an embodiment of this application provides a computer program product including a computer program, where the computer program, when run, causes a computer to perform a method performed by the controller according to the first aspect.

According to a seventh aspect, an embodiment of this application provides a chip. The chip includes a processor, and the processor is configured to invoke a computer program in a memory to perform a method performed by the controller according to the first aspect.

It should be understood that technical solutions according to the second aspect to the seventh aspect of this application correspond to a technical solution according to the first aspect of this application, and beneficial effects achieved according to the aspects and corresponding feasible implementations are similar. Details are not provided again.

### BRIEF DESCRIPTION OF DRAWINGS

FIG. 1 is a schematic diagram of a connection relationship between a battery protection board and a main board in a possible design;
FIG. 2 is a schematic diagram of a connection relationship between a battery protection board and a main board according to an embodiment of this application;
FIG. 3A is a schematic diagram of a structure of an EIS module according to an embodiment of this application;
FIG. 3B is a schematic diagram of a structure of a detection unit of an EIS module according to an embodiment of this application;
FIG. 3C is a schematic diagram of a structure of a detection unit of an EIS module according to an embodiment of this application;
FIG. 4A is a schematic diagram of a structure of an EIS module according to an embodiment of this application;
FIG. 4B is a schematic diagram of a structure of an EIS module according to an embodiment of this application;
FIG. 5 is a schematic diagram of a connection relationship between a battery protection board and a main board according to an embodiment of this application;
FIG. 6 is a schematic diagram of structures of an EIS module and an electricity meter when sharing an analog to digital converter according to an embodiment of this application;
FIG. 7 is a schematic diagram of a structure of a battery protection board according to an embodiment of this application;
FIG. 8 is a schematic diagram of a structure of a first module according to an embodiment of this application; and
FIG. 9 is a schematic structural diagram of a terminal device according to an embodiment of this application.

### DESCRIPTION OF EMBODIMENTS

For ease of understanding embodiments of this application, some terms as referred to in this application are first briefly described.
1. Electrochemical impedance spectroscopy (electrochemical impedance spectroscopy, EIS): Small-amplitude disturbance signals (for example, alternating sine electric potential waves) of different frequencies are applied to an electrochemical system (a battery), and a change of a ratio (namely, an impedance of the electrochemical system) of an alternating current electric potential to a current signal of the electrochemical system with a frequency ω of the disturbance signal, or a change of a phase angle f of the impedance with ω is measured, so that the impedance of the electrochemical system can be accurately analyzed.
2. Charge cutoff electric quantity: it may be understood as a total electric quantity charged into a battery when charging of the battery is stopped.

It should be noted that the charge cutoff electric quantity is related to a charge cutoff current and/or a charge cutoff voltage. The charge cutoff electric quantity may increase as the charge cutoff voltage increases, and may increase as the charge cutoff current decreases. On the contrary, the charge cutoff electric quantity may decrease as the charge cutoff voltage decreases, and may decrease as the charge cutoff current increases.

It may be understood that charging of a battery usually corresponds to two processes: constant-voltage charging and constant-current charging. Specifically, in a process of charging a battery, the battery is first charged in a terminal device with a fixed current until a voltage of the battery is a charge cutoff voltage. When the voltage of the battery is the charge cutoff voltage, the terminal device controls the battery to be maintained at the charge cutoff voltage, and gradually reduces the charging current until the charging current is less than or equal to a charge cutoff current.

3. Switch tube: The switch tube may be a metal oxide semiconductor field-effect transistor (metal oxide semiconductor field-effect transistor, MOSFET), may be an insulated gate bipolar transistor (insulated gate bipolar transistor, IGBT), may be a power triode, a gallium nitride (GaN) transistor, or the like, or may be another type of power device.

### 4. Other terms

In the embodiments of this application, words such as "first" and "second" are used to distinguish between same items or similar items with basically same functions and effects. For example, a first chip and a second chip are merely used to distinguish between different chips, and are not intended to limit a sequence of the first chip and the second chip. A person skilled in the art may understand that the words such as "first" and "second" do not limit a number or an execution sequence, and the words such as "first" and "second" do not indicate a definite difference.

It should be noted that in embodiments of this application, the terms such as "example" or "for example" are used to give an example, an illustration, or a description. Any embodiment or design solution described as "example" or "for example" in this application should not be construed as being preferred or advantageous over other embodiments or design solutions. Exactly, use of the term "exemplary" or "for example" is intended to present a concept in a specific manner.

In the embodiments of this application, "at least one" refers to one or more, and "a plurality of" refers to two or more. "And/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may represent a, b, c, "a and b", "a and c", "b and c", or "a, b, and c", where a, b, and c may be singular or plural.

### 5. Terminal device

A terminal device in embodiments of this application may be any form of electronic device. For example, the electronic device may include a handheld device, an in-vehicle device, and the like. For example, some electronic devices are as follows: a mobile phone (mobile phone), a tablet computer, a palmtop computer, a notebook computer, a mobile Internet device (mobile Internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in smart grid (smart grid), a wireless terminal in transportation safety (transportation safety), a wireless terminal in smart city (smart city), a wireless terminal in smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device, another processing device connected to a wireless modem, an in-vehicle device, the wearable device, a terminal device in a 5G network, a terminal device in a future evolved public land mobile network (public land mobile network, PLMN), and the like. This is not limited in the embodiments of this application.

By way of example but not limitation, in the embodiments of this application, the electronic device may alternatively be a wearable device. The wearable device may also be referred to as a wearable smart device, and is a collective term for wearable devices developed by intelligently designing daily wearing based on a wearable technology, for example, glasses, gloves, a watch, clothing, and shoes. The wearable device is a portable device that can be directly worn on the body or integrated into clothes or an accessory of a user. The wearable device is not only a hardware device, but also implements a powerful function through software support, data exchange, and cloud interaction. Generalized wearable intelligent devices include full-featured and large-size devices that can implement complete or partial functions without depending on smartphones, such as smart watches or smart glasses, and devices that focus on only one type of application and need to work with other devices such as smartphones, such as various smart bracelets or smart jewelry for monitoring physical signs.

In addition, in embodiments of this application, the electronic device may alternatively be a terminal device in an Internet of things (Internet of things, IoT) system. The IoT is an important part in future development of information technologies, and is mainly technically characterized in that things are connected to networks through communication technologies, to achieve intelligent networks of human-machine interconnection and interconnection between things.

The electronic device in the embodiments of this application may alternatively be referred to as: a terminal device, user equipment (user equipment, UE), a mobile station (mobile station, MS), a mobile terminal (mobile terminal, MT), an access terminal, a user unit, a user station, a mobile site, the mobile station, a remote station, a remote terminal, a mobile device, a user terminal, a terminal, a wireless communication device, a user agent, or a user apparatus.

In the embodiments of this application, the electronic device or each network device includes a hardware layer, an operating system layer that runs above the hardware layer, and an application layer that runs above the operating system layer. The hardware layer includes hardware such as a central processing unit (central processing unit, CPU), a memory management unit (memory management unit, MMU), and a memory (also referred to as a main memory). The operating system may be any one or more computer operating systems for implementing service processing through a process (process), for example, a Linux operating system, a Unix operating system, an Android operating system, an iOS operating system, or a windows operating system. The application layer includes applications such as Browser, Contacts, word processing software, and instant messaging software.

The terminal device is usually equipped with a battery, and the battery is configured to supply power to the terminal device. As use time of the terminal device increases, activity of chemical materials inside the battery gradually decreases, and the battery ages. Aging of the battery causes an internal resistance of the battery to increase. As an aging degree of a battery increases, a capacity of the battery may continuously decrease. Therefore, different charging policies need to be formulated according to the aging degree of the battery, to improve safety of the battery.

When a charging policy is formulated, a charge cutoff electric quantity is an important charging parameter. The charge cutoff electric quantity may be understood as a total electric quantity charged into the battery when the terminal device stops charging the battery. For example, a relatively high charge cutoff electric quantity may be set for a battery having a relatively low aging degree, so that the battery has more electric quantities when being fully charged, and a charging frequency is reduced. A relatively low charge cutoff electric quantity may be set for a battery having a relatively high aging degree, to reduce phenomena such as an excessively high temperature and bulging of the battery, and improve the safety.

If the terminal device inaccurately determines the aging degree of the battery, an actual aging degree of the battery may not match a charging policy, causing phenomena such as heat generation and bulging of the battery mounted in the terminal device. As a result, safety of the battery is low.

For example, in some possible designs, the aging degree of the battery may be reflected by a quantity of rounds, that is, a cycle value, in which the battery is fully charged and fully discharged. In the terminal device, each time the battery completes a round of full charging and full discharging, a cycle value recorded in a main board of the terminal device may be increased by 1. When an accumulated charging electric quantity of the battery is equal to 100% and an accumulated discharging electric quantity of the battery is equal to 100%, it may be determined that the battery completes a round of full charging and full discharging. In this way, for a battery that has been used for a relatively long time, a cycle value recorded in the main board of the terminal device may be a relatively large value, and for a battery that has not been used or a battery that has been used for a relatively short time, a cycle value recorded in the main board of the terminal device may be 0 or a relatively small value.

In other words, a larger cycle value recorded in the main board of the terminal device usually indicates a higher aging degree of the battery and a lower charge cutoff electric quantity in a charging policy. In this way, phenomena such as heat generation and bulging of the battery can be reduced. A smaller cycle value recorded in the main board of the terminal device usually indicates a lower aging degree of the battery and a higher charge cutoff electric quantity in a charging policy. In this way, the battery has more electric quantities when being fully charged, and a charging frequency is reduced.

However, when the battery and the main board of the terminal device are replaced, a case in which the cycle value recorded in the main board of the terminal device does not correspond to the aging degree of the battery may occur. Consequently, a charging policy does not match the aging degree of the battery, causing phenomena such as heat generation and bulging of the battery mounted in the terminal device.

For example, when the main board of the terminal device is replaced, because a main board after replacement is a new main board, a cycle value stored in the new main board is an initial value, and the initial value may be 0 or a smaller value. However, the battery has not been replaced, the battery may have been used for a relatively long time, and an actual cycle value of the battery is relatively large, that is, the cycle value of the new main board is less than the actual cycle value of the battery. Therefore, when the terminal device determines an aging status of the battery by using the cycle value in the new main board, the terminal device may pre-estimate a relatively low aging degree of the battery, and the terminal device uses a relatively loose charging policy, for example, the terminal device charges the battery with a relatively large charge cutoff electric quantity, causing phenomena such as heat generation and bulging of the battery mounted in the terminal device.

It may be understood that the charge cutoff electric quantity is related to a charge cutoff voltage and/or a charge cutoff current. The charge cutoff electric quantity may increase as the charge cutoff voltage increases, and may increase as the charge cutoff current decreases. Therefore, when the terminal device determines, according to the cycle value stored in the new main board, to use a charging policy in which a charge cutoff electric quantity is relatively large, a charge cutoff voltage of the terminal device may be larger than a charge cutoff voltage required by the battery, or a charge cutoff current in the terminal device may be smaller than a charge cutoff current required by the battery, causing phenomena such as heat generation and bulging of the battery in the terminal device.

Alternatively, for example, when a primary battery in the terminal device is replaced with a new battery, because the primary battery may have been used for a relatively long time, a cycle value stored in the main board is relatively large. However, an actual cycle value of the new battery is relatively small, that is, the cycle value of the main board is greater than the actual cycle value of the new battery. Therefore, when the terminal device determines an aging status of the battery by using the cycle value in the main board, the terminal device may pre-estimate a relatively high aging degree of the battery, and the terminal device may use a relatively strict charging policy. As a result, a part of electric quantity in the battery mounted in the terminal device is not completely used.

For example, when the terminal device determines a charging policy according to the cycle value stored in the main board, a charge cutoff voltage of the terminal device may be larger than a charge cutoff voltage required by the new battery, or a charge cutoff current in the terminal device may be smaller than a charge cutoff current required by the new battery. Consequently, a part of electric quantity of the new battery is not used, and the new battery cannot be fully charged, increasing a charging frequency of the terminal device.

In addition, even if both the main board and the battery in the terminal device are replaced, an aging degree of the battery is further related to a charging speed of the battery, a temperature of the battery, and the like, and a cycle value may not accurately reflect the aging degree of the battery. Therefore, when the terminal device determines the charge cutoff electric quantity of the battery based on the cycle value, the charge cutoff electric quantity of the battery is relatively small or relatively large. Consequently, the terminal device may also have problems such as bulging, heat generation, high power consumption, and a high charging frequency.

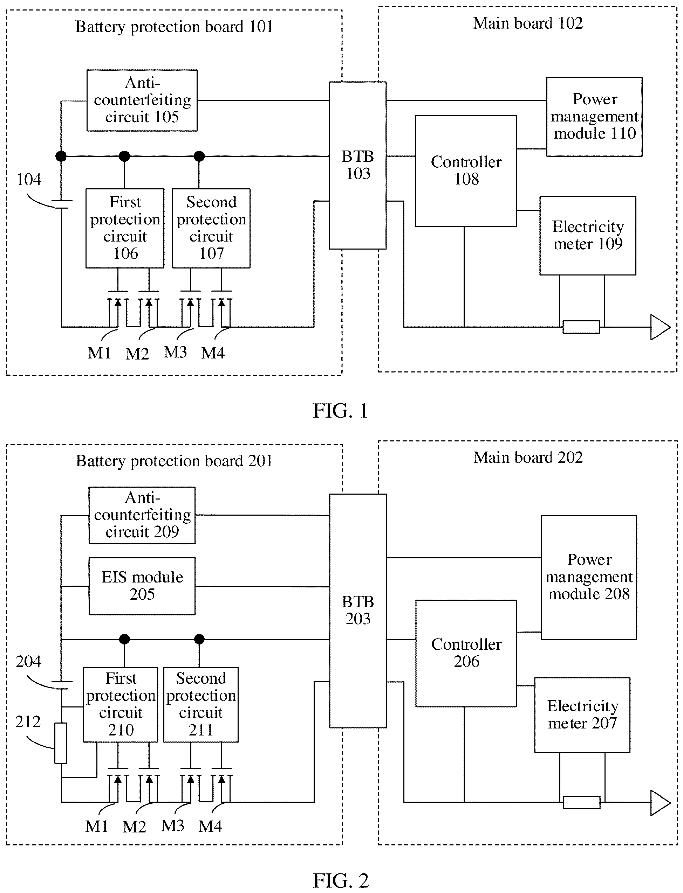

For example, FIG. 1 is a schematic diagram of a connection relationship between a battery protection board and a main board in a possible design. A structure shown in the schematic diagram may enable the terminal device to determine a charge cutoff electric quantity based on a cycle value in a main board in the foregoing descriptions.

As shown in FIG. 1, the terminal device includes: a battery protection board 101, a main board 102, and a board-to-board connector (board-to-board connector, BTB) 103. The battery protection board 101 and the main board 102 are connected by the BTB 103.

In FIG. 1, a battery 104, an anti-counterfeiting circuit 105, a first protection circuit 106, a first switch M1, a second switch M2, a second protection circuit 107, a third switch M3, and a fourth switch M4 are arranged in the battery protection board 101. A controller 108, an electricity meter 109, and a power management module 110 are arranged on the main board 102.

The anti-counterfeiting circuit 105 is connected to the controller 108, and the electricity meter 109 is connected to the power management module 110. The electricity meter 109 is connected to the controller 108. A first detection end of the first protection circuit 106 is connected to a positive electrode of the battery 104, a first control end of the first protection circuit 106 is connected to a control end of the first switch M1, a second control end of the first protection circuit 106 is connected to a control end of the second switch M2, a first detection end of the second protection circuit 107 is connected to the positive electrode of the battery 104, a first control end of the second protection circuit 107 is connected to a control end of the third switch M3, and a second control end of the second protection circuit 211 is connected to a control end of the fourth switch M4.

One connection end of the first switch M1 is connected to a negative electrode of the battery 104, the other connection end of the first switch M1 is connected to one connection end of the second switch M2, the other connection end of the second switch M2 is connected to one connection end of the third switch M3, the other connection end of the third switch M3 is connected to one connection end of the fourth switch M4, and the other connection end of the fourth switch M4 is connected to the negative electrode of the battery.

The battery 104 is configured to supply power to the battery protection board 101 and/or the main board 102.

The anti-counterfeiting circuit 105 is configured to store anti-counterfeiting information and/or battery-related information. The anti-counterfeiting information is used for indicating whether the battery is a genuine battery. The battery-related information includes one or more of the following: a battery type, a cell lifetime, a battery sequence number, and the like.

Adaptively, the controller 108 may obtain the anti-counterfeiting information and/or the battery-related information stored in the anti-counterfeiting circuit 105, and determine, based on the anti-counterfeiting information, whether the battery is the genuine battery. When the battery is the genuine battery, the terminal device is normally used. When the battery is not the genuine battery, normal use of the terminal device may be prohibited. In this way, a battery used by a terminal device may be a regular battery certified by a terminal manufacturer, to protect benefits of the manufacturer and reduce security risks brought by a forged poor-quality battery.

The first protection circuit 106 is configured to: when detecting that the battery 104 has a phenomenon of overvoltage, undervoltage, and/or overcurrent, control the first switch M1 and/or the second switch M2 to be turned off.

The second protection circuit 107 is configured to: when detecting that the battery 104 has the phenomenon of overvoltage, undervoltage, and/or overcurrent, control the third switch M3 and/or the fourth switch M4 to be turned off.

The overvoltage of the battery may refer to a phenomenon in which voltages at two ends of the battery are excessively high. The undervoltage of the battery may refer to a phenomenon in which voltages at two ends of the battery are excessively low. The overcurrent phenomenon of the battery may refer to a phenomenon in which a current flowing through the battery is greater than a rated current of the battery, and the overcurrent of the battery may include charging overcurrent and discharging overcurrent. It should be noted that the overvoltage and the overcurrent of the battery may cause phenomena such as heat generation and bulging of the battery. The undervoltage of the battery may cause excessive discharging of the battery, and consequently, a lifetime of the battery is reduced.

The first protection circuit 106 may be understood as first reprotection for the battery, and the second protection circuit 107 may be understood as second reprotection for the battery.

Generally, the first reprotection and the second reprotection are not triggered simultaneously, and a voltage threshold or a current threshold corresponding to the first reprotection is less than a voltage threshold or a current threshold corresponding to the second reprotection.

A principle that the first protection circuit 106 and the second protection circuit 107 provide dual protection for the battery is briefly described by using charging overcurrent protection as an example. In a charging process, when a current flowing through the battery 104 is greater than a first current threshold preset by the first protection circuit 106, the first protection circuit 106 may control the first switch M1 and/or the second switch M2 to be opened, to interrupt the current flowing through the battery 104. If the first protection circuit 106 fails and cannot cut off a charging loop in time, the first protection circuit 106 continues to charge the battery 104. When a current flowing through the battery 104 is greater than a current threshold preset by the second protection circuit 106, the second protection circuit 107 may control the third switch M3 and/or the fourth switch M4 to be turned off, to interrupt the current flowing through the battery 104.

In this way, the battery may be protected by using the first protection chip, the second protection chip, and the first switch M1 to the fourth switch M4, to implement safe use of the battery.

The electricity meter 109 is configured to detect a parameter of the battery, and transmit the detected parameter of the battery and the like to the controller 108. The parameter of the battery may include: a voltage value, a current, a temperature, and the like of the battery.

The electricity meter 109 is further configured to determine an electric quantity charged to the battery, an electric quantity discharged by the battery, a remaining electric quantity of the battery, and the like based on the parameter of the battery. Each time the battery completes one round, a cycle value stored by the controller 108 is increased by 1.

For example, when the battery is charged, the electricity meter 109 may detect a charging current of the battery in real time, and obtain the electric quantity charged to the battery according to a product of the charging current and time. When the battery is discharged, the electricity meter 109 may detect a discharging current of the battery in real time, and obtain the electric quantity discharged by the battery according to a product of the discharging current and time. The electricity meter 109 may calculate the remaining electric quantity of the battery according to a difference between the electric quantity charged to the battery and the electric quantity discharged by the battery.

The controller 108 is configured to determine a charging policy of the battery based on a stored cycle value, and transmit a control signal and the like to the power management module 110. The control signal includes: the charging policy. Adaptively, the power management module 110 is configured to control charging of the battery according to the charging policy in the control signal.

For example, the controller 108 is configured to determine, based on a stored cycle value of a quantity of rounds in which the battery is fully charged and fully discharged, a charge cutoff voltage and/or a charge cutoff current that should be used during charging of the battery, and send a control signal to the power management module 110. The power management module 110 controls charging of the battery according to the charge cutoff voltage and/or the charge cutoff current in the control signal.

The controller 108 may be an SOC chip, a processor, or the like in the terminal device. The power management module 110 may be a charging chip charger or a power management chip (power management IC, PMIC) in the terminal device. This is not limited in this embodiment of this application.

However, a circuit shown in FIG. 1 may have a case in which the cycle value stored in the controller does not match an actual cycle value of the battery, for example, the battery and/or the main board in the terminal device are both disassembled. Details are not described. Consequently, the battery is not fully charged for a long time, abnormal phenomena such as heat generation and bulging occur, and safety of the battery is low.

In view of this, an embodiment of this application provides a power supply circuit. An impedance module is added to the terminal device to detect an impedance of the battery, and an internal resistance of the battery is determined according to the impedance of the battery, so that an aging degree of the battery mounted in the terminal device is determined. Because the internal resistance of the battery may represent a condition inside the battery, and the aging degree of the battery determined by using the internal resistance of the battery is more accurate, the terminal device may determine an appropriate charging policy based on the accurate aging degree of the battery, to reduce a phenomenon such as heat generation, bulging, or insufficient discharging of the battery caused by mismatching between the charging policy and the aging degree of the battery.

For example, FIG. 2 is a schematic diagram of a connection relationship between a battery protection board 201 and a main board 202 according to an embodiment of this application. As shown in FIG. 2, the terminal device includes: a battery protection board 201, a main board 202, and a board-to-board connector (board-to-board connector, BTB) 203. The battery protection board 201 and the main board 202 are connected by the BTB 203.

A battery 204 and an EIS module 205 are arranged in the battery protection board 201. A controller 206 and a power management module 208 are arranged on the main board 102. The battery 204 is configured to supply power to the battery protection board 201 and the main board 202.

The EIS module 205 is configured to detect an internal resistance of the battery 204.

In this embodiment of this application, the EIS module 205 may output disturbance signals of a plurality of frequencies to the battery 204 and detect a plurality of voltage signals output by the battery 204 under the disturbance signals. The EIS module 205 processes the plurality of voltage signals to obtain the internal resistance of the battery 204. For example, the EIS module 205 processes the plurality of voltage signals to obtain impedances of the battery 204 at different frequencies. The EIS module 205 performs fitting analysis on the impedances of the battery 204 at a plurality of frequencies and an equivalent circuit model (EMC), to obtain the internal resistance of the battery. The disturbance signal may include, for example, a sine wave signal, a square wave signal, or a quasi-square wave signal. The quasi-square wave signal is a signal that is approximate to the square wave signal. For a structure, an operating principle, and the like of the EIS module 205, refer to the following corresponding descriptions. Details are not described herein.

It may be understood that the EIS module 205 performs detection when the battery has no load or a relatively small load and the battery is in a steady state, to obtain a relatively accurate detection result. The terminal device may determine a size of the load in the circuit by using a current of the battery and whether the circuit is stable. Therefore, in some embodiments, when the terminal device determines that duration over which a current of the battery is less than a first threshold lasts for first duration, the terminal device controls the EIS module to start EIS detection. In this way, accuracy of a measurement result can be improved.

The first threshold may be 10 mA, 20 mA, or any other value. This is not limited herein. The first duration may be 0.5 hours, may be 1 hour, or may be any other value. This is not limited herein.

In this embodiment of this application, the controller 206 may be a system on chip (system on chip, SOC), a processor, a micro control unit (micro control unit, MCU), or the like in the terminal device. The power management module 208 may be a charging chip charger or a power management chip (power management IC, PMIC) in the terminal device. This is not limited in this embodiment of this application.

The controller 206 is configured to determine a charging parameter of the battery based on the internal resistance of the battery. The controller 206 is configured to send a first control signal to the power management module 208. The first control signal includes: the charging parameter. Adaptively, the power management module 208 is configured to control the charging parameter of the battery according to the first control signal. In this way, the terminal device may adjust the charging parameter of the battery based on an aging degree of the battery, to reduce an overcharging situation of the battery, reduce phenomena such as heat generation and bulging of the battery, and prolong a battery lifetime.

For example, the charging parameter of the battery 204 includes one or more of the following: a charge cutoff voltage, a charge cutoff current, and the like.

For example, the controller 206 determines the charge cutoff voltage and/or the charge cutoff current of the battery 204 based on the internal resistance of the battery, and sends the first control signal to the power management module 208. Adaptively, the power management module 208 is configured to control the charge cutoff voltage and/or the charge cutoff current of the battery 204 according to the first control signal.

In some embodiments, the controller 206 pre-stores a correspondence between an internal resistance of the battery and a charge cutoff voltage. The controller 206 determines, based on the internal resistance of the battery that is detected by the EIS module 205 and the correspondence, a charge cutoff voltage that should be used during charging of the battery. Adaptively, the power management module 208 is configured to control the battery to be charged according to the charge cutoff voltage. The internal resistance of the battery may be inversely proportional to the charge cutoff voltage.

In some other embodiments, the controller 206 pre-stores a correspondence between an internal resistance of the battery and a charge cutoff current. The controller 206 determines, based on the internal resistance of the battery that is detected by the EIS module 205 and the correspondence, a charge cutoff current that should be used during charging of the battery. Adaptively, the power management module 208 is configured to control the battery to be charged according to the charge cutoff current. The internal resistance of the battery may be directly proportional to the charge cutoff current.

The controller 206 may alternatively obtain, in any other manner, a charge cutoff voltage and/or a charge cutoff current that should be used during charging of the battery. This is not limited herein.

Based on the foregoing embodiments, the controller 206 is further configured to determine a discharging parameter of the battery based on the internal resistance of the battery, and send a second control signal to the power management module 208. The second control signal further includes: the discharging parameter. Adaptively, the power management module 208 is configured to control the discharging parameter of the battery based on the second control signal. In this way, the terminal device may adjust the discharging parameter of the battery based on the aging degree of the battery, to reduce an overdischarging situation of the battery and prolong the battery lifetime.

For example, the discharging parameter of the battery includes one or more of the following: a discharge cutoff voltage, a discharge cutoff current, and the like.

In some embodiments, the controller 206 pre-stores a correspondence between an internal resistance of the battery and a discharge cutoff voltage. The controller 206 determines, based on the internal resistance of the battery that is detected by the EIS module 205 and the correspondence, a discharge cutoff voltage that should be used during discharging of the battery. Adaptively, the power management module 208 is configured to control the battery to be discharged according to the discharge cutoff voltage. The internal resistance of the battery may be directly proportional to the discharge cutoff voltage.

In some other embodiments, the controller 206 pre-stores a correspondence between an internal resistance of the battery and a discharge cutoff current. The controller 206 determines, based on the internal resistance of the battery that is detected by the EIS module 205 and the correspondence, a discharge cutoff current that should be used during discharging of the battery. Adaptively, the power management module 208 is configured to control the battery to be discharged according to the discharge cutoff current. The internal resistance of the battery may be inversely proportional to the discharge cutoff current.

The controller may alternatively obtain, in any other manner, a discharge cutoff voltage and/or a discharge cutoff current that should be used during discharging of the battery. This is not limited herein.

It may be understood that the controller 206 may simultaneously send the first control signal and the second control signal to the power management module 208. Alternatively, the controller 206 first sends the first control signal to the power management module 208, and then sends the second control signal to the power management module 208. A sequence of the first control signal and the second control signal is not limited in this embodiment of this application. In this embodiment of this application, the first control signal and the second control signal may be a same control signal, or may be different control signals. This is not limited herein.

Based on the foregoing embodiments, the battery protection board further includes: an anti-counterfeiting circuit, a first protection circuit, a second protection circuit, and the like. As shown in FIG. 2, the battery protection board further includes: an anti-counterfeiting circuit 209, a first protection circuit 210, a second protection circuit 211, a first switch M1, a second switch M2, a third switch M3, and a fourth switch M4.

For connection relationships among the anti-counterfeiting circuit 209, the first protection circuit 210, the second protection circuit 211, the first switch M1, the second switch M2, the third switch M3, and the fourth switch M4, and specific functions of the components, refer to the descriptions in FIG. 1. Details are not described herein again.

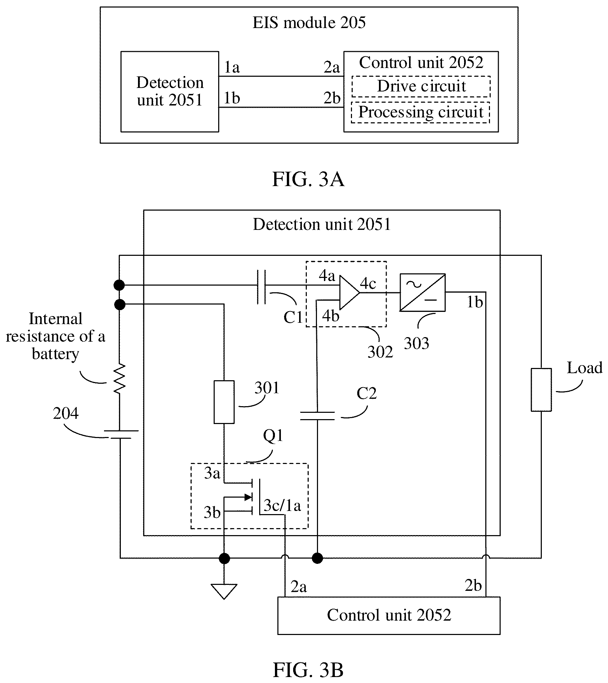

The following exemplarily describes a structural implementation and an algorithm implementation of the EIS module. FIG. 3A is a schematic diagram of a structure of an EIS module 205. FIG. 3B to FIG. 4B are each a schematic diagram of a structure of a detection unit 2051 in an EIS module 205.

For example, FIG. 3A is a schematic diagram of a structure of an EIS module according to an embodiment of this application. As shown in FIG. 3A, the EIS module 205 includes a detection unit 2051 and a control unit 2052. An input end 1a of the detection unit 2051 is connected to a first end 2a of the control unit 2052, and an output end 1b of the detection unit 2051 is connected to a second end 2b of the control unit 2052.

In this embodiment of this application, the control unit 2052 may control, through the first end 2a, the detection unit 2051 to generate disturbance signals of a plurality of frequencies. The detection unit 2051 may detect a plurality of voltage signals output by the battery under the plurality of disturbance signals, and converts the plurality of voltage signals into a plurality of digital signals. The voltage signal includes: an alternate current voltage signal of the battery 204 caused by the disturbance signal, or a superimposed signal of an alternate current voltage signal of the battery 204 caused by the disturbance signal and a direct current voltage signal output by the battery 204.

The control unit 2052 may obtain, through the second end 2b, the plurality of digital signals detected by the detection unit 2051, and obtain an internal resistance of the battery based on the plurality of digital signals.

For example, the control unit 2052 may obtain, by using the plurality of data signals, impedances of the battery corresponding to a plurality of frequencies. The control unit 2052 obtains the internal resistance of the battery by performing fitting processing on the plurality of impedances of the battery. A processing process in which the control unit 2052 obtains the internal resistance of the battery based on the plurality of digital signals is not limited in this embodiment of this application.

In some embodiments, the control unit 2052 may control, through the first end 2a, the detection unit 2051 to generate sine waves of a plurality of frequencies. The detection unit 2051 detects voltage signals output by the battery at a plurality of frequencies, and converts the plurality of voltage signals into a plurality of digital signals. The control unit 2052 may process, through the second end 2b, the plurality of digital signals detected by the detection unit 2051, to obtain the internal resistance of the battery. In this way, the EIS module can detect the internal resistance of the battery.

For example, the detection unit 2051 may output, through a current generator, a sine wave needed by a test. The detection unit 2051 of the EIS module 205 may convert, through an analog to digital converter (analog to digital converter, ADC), voltage signals that are output by the battery and that are obtained through test by the detection unit 2051 into digital signals used for representing impedances of the battery, so as to facilitate subsequent processing by the control unit 2052.

In some other embodiments, the control unit 2052 may control, through the first end 2a, the detection unit 2051 to generate square waves or quasi-square waves of a plurality of frequencies. The detection unit 2051 detects voltage signals output by the battery under the plurality of frequencies, and converts the plurality of voltage signals into a plurality of digital signals. The control unit 2052 may process, through the second end 2b, the plurality of digital signals detected by the detection unit 2051, to obtain the internal resistance of the battery. In this way, the EIS module can detect the internal resistance of the battery. In addition, the square wave is easy to obtain, and this manner is easy to implement.

As shown in FIG. 3A, the control unit 2052 may include a drive circuit and a processing circuit. The drive circuit is configured to drive a switch tube in the detection unit 2051 to be turned on or turned off, to control the detection unit 2051 to output square waves or quasi-square waves to the battery 204. The processing circuit is configured to process the plurality of digital signals output by the detection unit 2051, to obtain the internal resistance of the battery.

For example, the processing circuit may process the plurality of digital signals output by the detection unit 2051, to obtain impedances of the battery at a plurality of frequencies, and obtain the internal resistance of the battery based on changes of the impedances.

The control unit 2052 may be an MCU or another control structure. A specific structure, a position, and the like of the control unit 2052 are not specifically limited in this embodiment of this application.

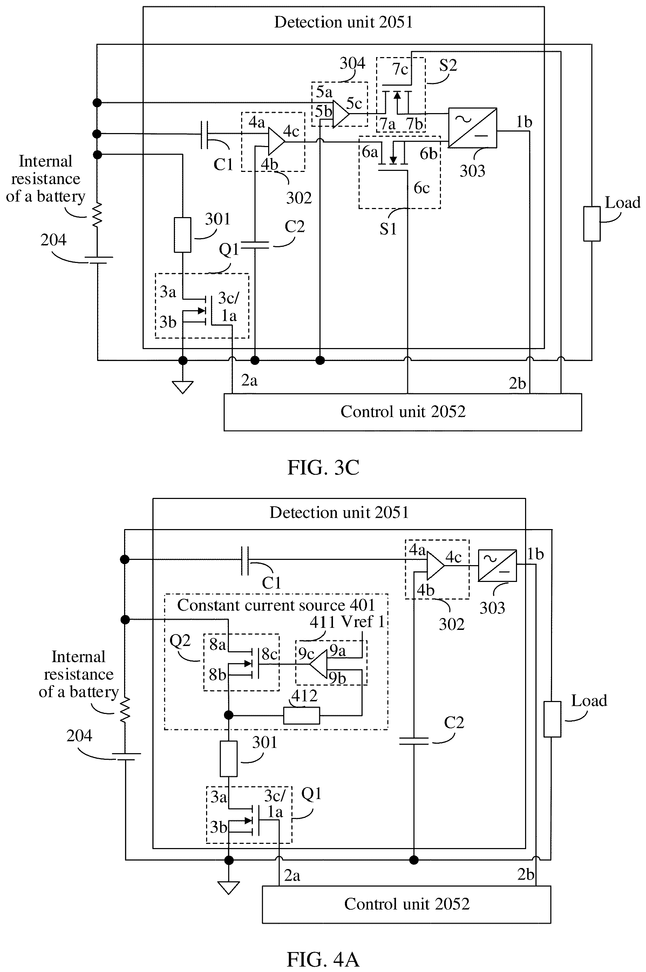

The following describes a structure and a working process of the detection unit 2051 of the EIS module with reference to FIG. 3B and FIG. 3C.

For example, FIG. 3B is a schematic diagram of a structure of a detection unit 2051 of an EIS module according to an embodiment of this application. As shown in FIG. 3B, the detection unit 2051 includes: a resistor 301, a switch tube Q1, a first differential amplifier 302, and an analog to digital converter 303.

One end of the resistor 301 is connected to a positive electrode of the battery 204, the other end of the resistor 301 is connected to a first electrode 3a of the switch tube Q1, and a second electrode 3b of the switch tube Q1 is grounded. A first input end 4a of the first differential amplifier 302 is connected to the positive electrode of the battery 204. A second input end 4b of the first differential amplifier 302 is connected to a negative electrode of the battery 204, and an output end 4c of the first differential amplifier 302 is connected to an input end of the analog to digital converter 303. A control electrode 3c of the switch tube Q1 is the input end 1a of the detection unit 2051, the control electrode 3c of the switch tube Q1 is connected to the first end 2a of the control unit 2052, an output end of the analog to digital converter 303 is the output end 1b of the detection unit 2051, and the output end of the analog to digital converter 303 is connected to the second end 2b of the control unit 2052.

The switch tube Q1 is configured to be turned on or turned off under control of the control unit 2052, to generate a disturbance signal.

It should be noted that the switch tube Q1 is configured to be turned on or turned off under control of the control unit 2052, and may generate a quasi-square wave changing voltage or a square wave changing voltage at the battery 204.

It should be noted that the quasi-square wave changing voltage or the square wave changing voltage may be decomposed into sine waves of different frequencies through Fourier. It may be understood that the switch tube Q1 is turned on, so that the battery 204, the resistor 301, and the switch tube Q1 form a loop, and a current flows through the resistor 301. The switch tube Q1 is alternately turned on and turned off, so that voltages at two ends of the battery 204 change. In this case, the detection unit 2051 outputs disturbance signals to the battery 204.

For example, a switching frequency of the switch tube Q1 may range from 0.1 Hz to 10 KHz. In this way, voltage signals output by the battery under low-frequency and highfrequency disturbance signals are measured, to improve accuracy of the internal resistance.

In some embodiments, a value of the resistor 301 may range from 5 Ohm to 200 Ohm. In this way, the resistor 301 may correspond to the internal resistance of the battery, so that an alternate current voltage signal generated by the battery 204 due to the disturbance signal is more obvious, to improve accuracy of a test result.

The first differential amplifier 302 is configured to amplify a difference between a voltage at the positive electrode of the battery 204 and a voltage at the negative electrode of the battery 204 based on a first amplification coefficient, so that a difference between signals is more obvious, thereby improving accuracy of subsequent signal processing. The first amplification coefficient may be a preset fixed value, or may be dynamically adjustable under control of the control unit 2052, so that a voltage value output by the first differential amplifier 302 can meet a performance requirement of the magic converter 303. This is not specifically limited in this embodiment of this application.

The analog to digital converter 303 is configured to convert a voltage signal output by the first differential amplifier 302 into a digital signal. Further, the detection unit 2051 may calculate the internal resistance of the battery after obtaining digital signals of disturbance signals of a plurality of frequencies.

For example, the control unit 2052 may perform Fourier transform on a plurality of digital signals, to obtain voltage values corresponding to a plurality of frequencies, and calculate ratios of the voltage values corresponding to the plurality of frequencies to a current flowing through the resistor 301, to obtain impedances of the battery 204 at the plurality of frequencies. The control unit 2052 obtains the internal resistance of the battery by performing fitting processing on the impedances of the battery at the plurality of frequencies.

The following describes the working process of the EIS module with reference to FIG. 3B.

When duration over which a current of the battery is less than a first threshold lasts for first duration, the control unit 2051 outputs at least N disturbance signals to the switch tube Q1. The N disturbance signals correspond to different frequencies. duty cycles of the N disturbance signals may be the same. The duty cycle may be understood as a ratio of power-on time to total time in one pulse cycle. A value of the duty cycle is not limited. For example, when the duty cycle has a value of 50%, subsequent calculation may be facilitated.

An example in which a frequency of a first disturbance signal is a first frequency is used. The switch tube Q1 is turned on or turned off at the first frequency, and duration over which the switch tube Q1 is turned on is the same as duration over which the switch tube Q1 is turned off. Adaptively, voltages at two ends of the battery 204 change according to the first frequency. The first differential amplifier calculates a difference between a voltage at the positive electrode of the battery 204 and a voltage at the negative electrode of the battery 204, to obtain a voltage signal of the battery 204 at the first frequency.

The analog to digital converter 303 converts the voltage signal of the battery 204 at the first frequency into a digital signal corresponding to the first disturbance signal, and transmits the digital signal corresponding to the first disturbance signal to the control unit of the EIS module 205.

For other signals than the first disturbance signal in the N disturbance signals, the control unit 2051 can also obtain a digital signal of each of the other disturbance signals, so that the control unit 2051 may obtain changes of impedances of the battery 204 at different frequencies based on digital signals corresponding to the N disturbance signals, to obtain the internal resistance of the battery 204.

Specifically, the control unit 2052 may perform Fourier decomposition on digital signals corresponding to a plurality of frequencies, to obtain a voltage spectrum output by the battery 204 at the plurality of frequencies, and then perform algorithm processing on the voltage spectrum output by the battery 204 at the plurality of frequencies, to obtain the internal resistance of the battery. For example, the algorithm processing may be performing processing based on the voltage spectrum output by the battery 204 at the plurality of frequencies to obtain an EIS impedance spectrum graph. Fitting analysis is performed on the EIS impedance spectrum graph and an equivalent model, to obtain the internal resistance of the battery.

In this way, the disturbance signal is output to the battery through the switch tube. This manner is simple and easy to implement. In addition, the switch tube has a relatively small size and occupies a small area.

Based on the structure shown in FIG. 3B, the EIS module 205 further includes: a capacitor C1 and/or a capacitor C2. The capacitor C1 is located between the battery and the first differential amplifier. The capacitor C2 is located between the first differential amplifier and the second electrode of Q1. In this way, a direct current voltage signal in the voltage signal of the battery 204 can be filtered out, and interference of the direct current voltage signal to an alternate current voltage signal can be reduced, thereby improving accuracy of a test result.

In some embodiments, a value of the capacitor C1 ranges from 0.1 to 2.2 microfarads. A value of the capacitor C2 ranges from 0.1 to 2.2 microfarads.

For example, one end of the capacitor C1 is connected to the positive electrode of the battery 204, and the other end of the capacitor C1 is connected to the first input end 4a of the first differential amplifier 302. One end of the capacitor C2 is connected to the negative electrode of the battery 204, and the other end of the capacitor C2 is connected to the second input end 4b of the first differential amplifier 302.

In this way, the capacitor C1 can filter out a direct current voltage signal input to the first input end of the first differential amplifier 302. The capacitor C2 may filter out a direct current voltage signal input to the second input end of the first differential amplifier 302, to reduce interference of the direct current voltage signal to an alternate current voltage signal, and improve test accuracy.

It should be noted that the capacitor C1 and the capacitor C2 may filter out the direct current voltage of the battery, so that a pressure difference obtained by the first comparator 302 is a pressure difference generated by disturbance signals at two ends of the battery. Because the disturbance signal usually has a relatively small current value, the pressure difference obtained by the first comparator 302 is relatively small, and a voltage signal transmitted by the first comparator 302 to the analog to digital converter 303 is relatively small. Further, the power supply circuit may use an analog to digital converter with a relatively low specification requirement, to reduce costs of the power supply circuit.

It may be understood that when a frequency of a disturbance signal is relatively small, an alternate current voltage signal of the battery caused by the disturbance signal is similar to the direct current voltage signal, and the capacitor C1 and the capacitor C2 may filter out a part of the alternate current voltage signal, causing a relatively small voltage value corresponding to the alternate current voltage signal output by the first differential amplifier. As a result, a test structure of the power supply circuit is inaccurate.

In some embodiments, the EIS module includes two detection paths. One detection path includes the capacitor C1 and the capacitor C2, and the other detection path does not include the capacitor C1 and the capacitor C2. When the switching frequency is relatively high, a voltage signal output by the battery 204 is collected through the path including the capacitor C1 and the capacitor C2. When the switching frequency is relatively low, a voltage signal output by the battery 204 is collected through the path in which the capacitor C1 and the capacitor C2 are not arranged. In this way, different paths are respectively used based on a value of the switching frequency. When the switching frequency is relatively high, a direct current component is filtered out through the capacitor, to reduce interference of the direct current voltage signal, so that the alternate current voltage signal is more accurate, thereby improving accuracy of a test result. When the switching frequency is relatively low, the direct current component is not filtered out, to reduce impact of the capacitor on the alternate current voltage signal, and improve test accuracy.

For example, FIG. 3C is a schematic diagram of a structure of an EIS module according to an embodiment of this application. As shown in FIG. 3C, the EIS module includes: a resistor 301, a switch tube Q1, a first differential amplifier 302, an analog to digital converter 303, a capacitor C1, a capacitor C2, a switch S1, a switch S2, and a fifth differential amplifier 304. In the EIS module, one detection path includes the battery 204, the capacitor C1, the capacitor C2, the first differential amplifier 302, the switch S1, and the analog to digital converter 303. The other detection path includes the battery 204, the fifth differential amplifier 304, the switch S2, and the analog to digital converter 303.

For connections among the resistor 301, the switch tube Q1, the first differential amplifier 302, the analog to digital converter 303, the capacitor C1, and the capacitor C2 and functions thereof, refer to the foregoing corresponding descriptions. Details are not described herein again.

A first input end 5a of the fifth differential amplifier 304 is connected to the positive electrode of the battery 204, and a second input end 5b of the fifth differential amplifier 304 is connected to the negative electrode of the battery 204. A first electrode 6a of the switch S1 is connected to an output end 5c of the first differential amplifier 302, a second electrode 6b of the switch S1 is connected to the analog to digital converter 303, and a control electrode 6c of the switch S1 is controlled by the control unit 2052. A first electrode 7a of the switch S2 is connected to the output end 5c of the fifth differential amplifier 304, a second electrode 7b of the switch S2 is connected to the analog to digital converter 303, and a control electrode 7c of the switch S2 is controlled by the control unit 2052.

A function of the fifth differential amplifier 304 is similar to that of the first differential amplifier. Details are not described herein again.

In this embodiment of this application, the switch S1 and the switch S2 may be single pole single throw switches or may be switch tubes. The switch S1 and the switch S2 each may alternatively be replaced with another structure that can implement a same function, for example, a single pole double throw switch. Replacement structures of the switch S1 and the switch S2 are not specifically limited in this embodiment of this application.

An example in which both the switch S1 and the switch S2 are switch tubes is used. The control unit 2052 is configured to: when a switching frequency of the switch tube Q1 is greater than a first value, control the switch S1 to be turned on and the switch S2 to be turned off, so that the first differential amplifier 302 is connected to the analog to digital converter 303. In this way, the detection unit 2051 filters out a direct current component through the capacitor C1 and the capacitor C2, and the first differential amplifier 302 collects voltages at two ends of the battery 204, to obtain voltage signals output by the battery 204.

The control unit 2052 is further configured to: when the switching frequency of the switch tube Q1 is less than or equal to the first value, control the switch S1 to be turned off and the switch S2 to be turned on, so that the fifth differential amplifier 304 is connected to the analog to digital converter 303. The detection unit 2051 collects voltages at two ends of the battery 204 through the fifth differential amplifier 304, to obtain voltage signals output by the battery 204.

The first value may be 100 Hz, 1000 Hz, or any other value. A specific value of the first value is not limited in this embodiment of this application.

In this way, there are two paths for detecting a voltage, and different paths are respectively used based on a value of a switching frequency. When the switching frequency is relatively high, a direct current component is filtered out through a capacitor, so that a voltage signal is more accurate, thereby improving accuracy of a test result. When the switching frequency is relatively low, impact of the capacitor on an alternate current voltage signal is reduced, thereby improving test accuracy.

Based on the foregoing embodiments, the detection unit 2051 further includes: a constant current source. The constant current source is configured to stabilize a current flowing through the resistor 301. In this way, during EIS test, a current output by the battery is stable, so that a test error caused by an unstable current can be reduced, precision of the EIS test can be improved, and accuracy of the internal resistance of the battery can be improved.

It may be understood that, in the foregoing embodiments, the current flowing through the resistor 301 may be determined through the constant current source, or may be determined in any other manner. This is not limited herein.

In this embodiment of this application, the constant current source may be located between the battery 204 and the resistor 301, or may be located between the resistor 301 and the switch tube Q1.

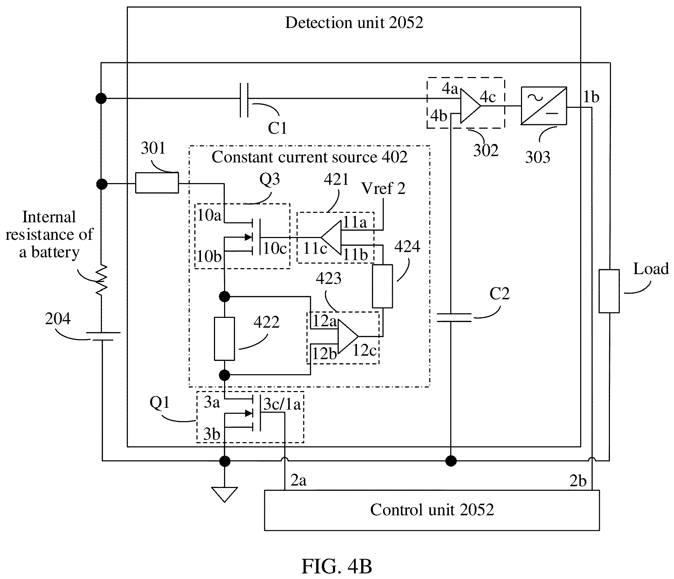

Structures of two types of constant current sources are described below with reference to FIG. 4A and FIG. 4B.

For example, FIG. 4A is a schematic diagram of a structure of an EIS module according to an embodiment of this application. For example, as shown in FIG. 4A, the detection unit 2051 includes: the resistor 301, the switch tube Q1, the first differential amplifier 302, the analog to digital converter 303, and a constant current source 401.

In a circuit shown in FIG. 4A, the constant current source 401 is located between the battery 204 and the resistor 301. One end of the constant current source 401 is connected to the battery 204, and the other end of the constant current source 401 is connected to one end of the resistor 301.

It may be understood that the constant current source 401 may alternatively be located between the resistor 301 and the switch tube Q1. One end of the constant current source 401 is connected to the resistor 301, and the other end of the constant current source 401 is connected to the first electrode 3a of the switch tube Q1. A specific position of the constant current source 401 is not limited in this embodiment of this application.

In this embodiment of this application, the constant current source 401 includes: a second differential amplifier 411, a resistor 412, and a switch tube Q2.

An example in which the constant current source 401 is located between the battery 204 and the resistor 301 is used, a first electrode 8a of the switch tube Q2 is connected to the positive electrode of the battery 204, a second electrode 8b of the switch tube Q2 is connected to one end of the resistor 301, the second electrode 8b of the switch tube Q2 is connected to one end of the resistor 412, a control electrode 8c of the switch tube Q2 is connected to an output end 9c of the second differential amplifier 411, and a first input end 9a of the second differential amplifier 411 is configured to input a first reference voltage. A second input end 9b of the second differential amplifier 411 is connected to the other end of the resistor 412.

The second differential amplifier 411 is configured to adjust a voltage at the control electrode of the switch tube Q2 based on a voltage at the other end of the resistor 412 and the first reference voltage, to adjust a resistance of the switch tube Q2, so as to stabilize a voltage at one end of the resistor 412. Specifically, the second differential amplifier 411 may calculate a difference between the voltage at the other end of the resistor 412 and the first reference voltage, and adjust the voltage at the control electrode 8c of the switch tube Q2 based on the difference and a second amplification coefficient, to adjust the resistance of the switch tube Q2. The switch tube Q2 operates in a linear region, and the resistance of the switch tube Q2 is adjustable.

The second amplification coefficient may be a preset fixed value, or may be dynamically adjustable under control of the control unit 2052, so that a voltage value output by the second differential amplifier 411 can meet adjustment on the resistance of the switch tube Q2. This is not specifically limited in this embodiment of this application.

When a current flowing through the resistor 301 is relatively high, a voltage at one end of the resistor 412 is relatively high. The second differential amplifier 411 calculates a difference between a voltage at the other end of the resistance 412 and the first reference voltage, and adjusts a voltage at the control electrode 8c of the switch tube Q2 based on the difference and the second amplification coefficient, so that a resistance of the switch tube Q2 increases, the voltage at one end of the resistor 412 decreases, and the current flowing through the resistor 301 decreases.

When a current flowing through the resistor 301 is relatively low, a voltage at one end of the resistance 412 is relatively low, the second differential amplifier 411 calculates a difference between a voltage at the other end of the resistor 412 and the first reference voltage, and adjusts a voltage at the control electrode 8c of the switch tube Q2 based on the difference and the second amplification coefficient, so that a resistance of the switch tube Q2 decreases, the voltage at one end of the resistor 412 increases, and the current flowing through the resistor 301 increases.

In this way, the second differential amplifier collects voltages at the resistor 412 in real time, and adjusts the resistance of Q2 based on the voltages at the resistor 412 and the first reference voltage, so that the current flowing through the resistor 301 keeps stable.

For example, FIG. 4B is a schematic diagram of a structure of an EIS module according to an embodiment of this application. As shown in FIG. 4B, the detection unit 2051 includes: the resistor 301, the switch tube Q1, the first differential amplifier 302, the analog to digital converter 303, and a constant current source 402.

In a circuit shown in FIG. 4B, the constant current source 402 is located between the resistor 301 and the switch tube Q1. One end of the constant current source 402 is connected to the other end of the resistor 301, and the other end of the constant current source 402 is connected to the first electrode 3a of the switch tube Q1.

It may be understood that the constant current source 402 may alternatively be located between the battery 204 and the resistor 301. One end of the constant current source 402 is connected to the battery 204, and the other end of the constant current source 402 is connected to one end of the resistor 301.

In this embodiment of this application, the constant current source 402 includes: a switch tube Q3, a third differential amplifier 421, a sampling resistor 422, a fourth differential amplifier 423, and a resistor 424.

An example in which the constant current source 402 is located between the resistor 301 and the switch tube Q1, a first electrode 10a of the switch tube Q3 is connected to the other end of the resistor 301, a second electrode 10b of the switch tube Q3 is connected to one end of the sampling resistor 422, and a control electrode 10c of the switch tube Q3 is connected to an output end 11c of the third differential amplifier 421. The other end of the sampling resistor 422 is connected to the first electrode 3a of the switch tube Q1. A first input end 11a of the third differential amplifier 421 is configured to input a second reference voltage. A second input end 11b of the third differential amplifier 421 is connected to one end of the resistor 424. The other end of the resistor 424 is connected to an output end 12c of the fourth differential amplifier 423. One end of the sampling resistor 422 is connected to a first input end 12a of the fourth differential amplifier 423, and the other end of the sampling resistor 422 is connected to a second input end 12b of the fourth differential amplifier 423.

In some embodiments, a resistance of the sampling resistor 422 ranges from 0.75 Ohm to 100 Ohm.

An example in which the switch tube Q3 is an NMOS is used. A drain of the switch tube Q3 is connected to the positive electrode of the battery 204, a source of the switch tube Q3 is connected to one end of the sampling resistor 422, and a grid of the switch tube Q3 is connected to the output end of the third differential amplifier 421.

The fourth differential amplifier is configured to output a voltage based on voltages at two ends of the sampling resistor 422, where the voltage output by the fourth differential amplifier is directly proportional to a voltage difference between the two ends of the sampling resistor 422. It may be understood that the voltage output by the fourth differential amplifier 423 increases as the voltage difference between the two ends of the sampling resistor 422 increases and decreases as the voltage difference between the two ends of the sampling resistor 422 decreases.

The third differential amplifier 421 is configured to adjust a voltage at the control electrode 10c of the switch tube Q3 based on a difference between the second reference voltage and a voltage at one end of the resistor 424 and a third amplification coefficient, to adjust a resistance of the switch tube Q3, so as to stabilize the voltage difference between the two ends of the sampling resistor 422. Specifically, the third differential amplifier 421 may calculate the difference between the second reference voltage and the voltage at one end of the resistor 424, and adjust the voltage at the control electrode 10c of the switch tube Q3 based on the difference and the third amplification coefficient, to adjust the resistance of the switch tube Q3. The switch tube Q3 operates in a linear region, and the resistance of the switch tube Q3 is adjustable.

The third amplification coefficient may be a preset fixed value, or may be dynamically adjustable under control of the control unit 2052, so that a voltage value output by the third differential amplifier 421 can meet adjustment on the resistance of the switch tube Q3. This is not specifically limited in this embodiment of this application.

It may be understood that the voltage at one end of the resistor 424 corresponds to the voltage output by the fourth differential amplifier 423. It may also be understood that the third differential amplifier 421 is configured to adjust the voltage at the control electrode 10c of the switch tube Q3 based on the second reference voltage and the voltage output by the fourth differential amplifier 423, to adjust the resistance of the switch tube Q3.

When a current flowing through the resistor 301 is relatively high, a voltage difference between the two ends of the sampling resistor 422 is relatively high, a voltage output by the fourth differential amplifier 423 is relatively high, and a voltage at the other end of the resistor 424 is relatively high. The third differential amplifier 421 calculates a difference between the voltage at the other end of the resistor 424 and the second reference voltage, and adjusts a voltage at the control electrode 10c of the switch tube Q3 based on the difference and the third amplification coefficient, so that the resistance of the switch tube Q3 increases, a current flowing through the resistor 422 decreases, and the current flowing through the resistor 301 decreases.

When a current flowing through the resistor 301 is relatively low, a voltage difference between the two ends of the sampling resistor 422 is relatively low, a voltage output by the fourth differential amplifier 423 is relatively low, and a voltage at the other end of the resistor 424 is relatively low. The third differential amplifier 421 calculates a difference between the voltage at the other end of the resistor 424 and the second reference voltage, and adjusts a voltage at the control electrode 10c of the switch tube Q3 based on the difference and the third amplification coefficient, so that the resistance of the switch tube Q3 decreases, a current flowing through the resistor 422 increases, and the current flowing through the resistor 301 increases.

In this way, voltages at the two ends of the sampling resistor 422 may be collected, and feedback adjustment is performed on the resistance of the switch tube Q3 based on a voltage difference between the two ends of the sampling resistor 422, so that a current flowing through the resistor 301 keeps stable. In addition, in the constant current source shown in FIG. 4B, a resistance of the sampling resistor 422 is fixed, and that feedback adjustment is performed based on the voltage difference between the two ends of the sampling resistor 422 may be understood as that feedback adjustment is performed based on a current flowing through the sampling resistor 422, so that the current flowing through the resistor 301 is stable, to improve accuracy of the internal resistance of the battery subsequently calculated based on the current flowing through the resistor 301.

Correspondingly, accuracy of sampling an alternate current voltage signal of the battery by the first differential amplifier and the analog to digital converter may be reduced, and a requirement on accuracy of the analog to digital converter in the power supply circuit may be reduced, to reduce costs of the analog to digital converter.

In a possible implementation, a sampling resistor corresponding to the EIS module 205 and a sampling resistor corresponding to the first protection circuit 210 are a same resistor. For example, in FIG. 2, the first protection circuit 210 and/or the second protection circuit 211 detect/detects a voltage and the like of the battery 204 through the resistor 212. The resistor 301 and the resistor 212 in the EIS module 205 may be a same resistor. In this way, the resistor is reused, and a quantity of resistors on a battery protection board side can be reduced, to reduce space occupation and costs, and facilitate miniaturization of the terminal device.

It may be understood that, the anti-counterfeiting circuit 209, the first protection circuit 210, the second protection circuit 211, and the EIS module 205 may be independent modules, or may be a plurality of modules that are integrated together. For example, the anti-counterfeiting circuit 209, the first protection circuit 210, and the second protection circuit 211 are integrated. Alternatively, the anti-counterfeiting circuit 209, the first protection circuit 210, the second protection circuit 211, and the EIS module 209 are integrated together. In this way, an area occupied by the battery protection board can be reduced, and miniaturization of the terminal device is facilitated. A quantity and types of modules integrated together are not limited in this embodiment of this application.

Based on the foregoing embodiments, the power supply circuit further includes an electricity meter 207. The electricity meter 207 is configured to detect a parameter of the battery, and transmit the parameter of the battery and the like to the controller on a main board side. The parameter of the battery may include: a voltage value, a current, a temperature, and the like of the battery.

In a possible implementation, the controller 206 determines a charging parameter, a discharging parameter, and the like of the battery based on the internal resistance of the battery and the temperature of the battery. In this way, considering impact of the temperature of the battery on the internal resistance of the battery, a charging policy and a discharging policy are more accurate.

For example, the controller 206 stores a correspondence among an internal resistance of the battery, a temperature of the battery, and a charging parameter of the battery. The controller determines the charging parameter of the battery 204 based on the internal resistance of the battery 204, the temperature of the battery 204, and the correspondence. A specific correspondence is not limited in this embodiment of this application.

In some embodiments, the electricity meter 207 is connected to the power management module 208 (not shown in FIG. 2), and the electricity meter 207 transmits the temperature of the battery to the power management module 208. When the temperature of the battery 204 is less than or equal to a temperature set value, the power management module 208 charges the battery. Alternatively, when the temperature of the battery 204 is greater than a temperature set value, the power management module 208 stops charging the battery. In this way, when the temperature of the battery is relatively high, charging of the battery is stopped, to reduce overheat of the battery and improve safety of the battery.

In a possible implementation, the electricity meter 207 is further configured to perform electric quantity prediction based on a detected current of the battery 204. For example, the electricity meter 207 integrates a collected current flowing through the sampling resistor 212, to obtain an electric quantity output by the battery, and further predicts a remaining electric quantity of the battery, to display the remaining electric quantity of the battery on a display screen.

In some embodiments, the electricity meter 207 is further configured to update a relationship between an open circuit voltage (open circuit voltage, OCV) and an electric quantity based on the internal resistance of the battery, to improve accuracy of electric quantity evaluation of the battery, and an electric quantity prompt is more accurate, to improve user experience.

In some embodiments, the electricity meter 207 includes: a sampling resistor, a differential amplifier, and an analog to digital converter an analog to digital converter. The differential amplifier obtains voltage signals of the sampling resistor based on voltages at two ends of the sampling resistor. The analog to digital converter the analog to digital converter converts the voltage signals of the sampling resistor into digital signals, to obtain a current flowing through the sampling resistor, so as to obtain an electric quantity output by the battery.

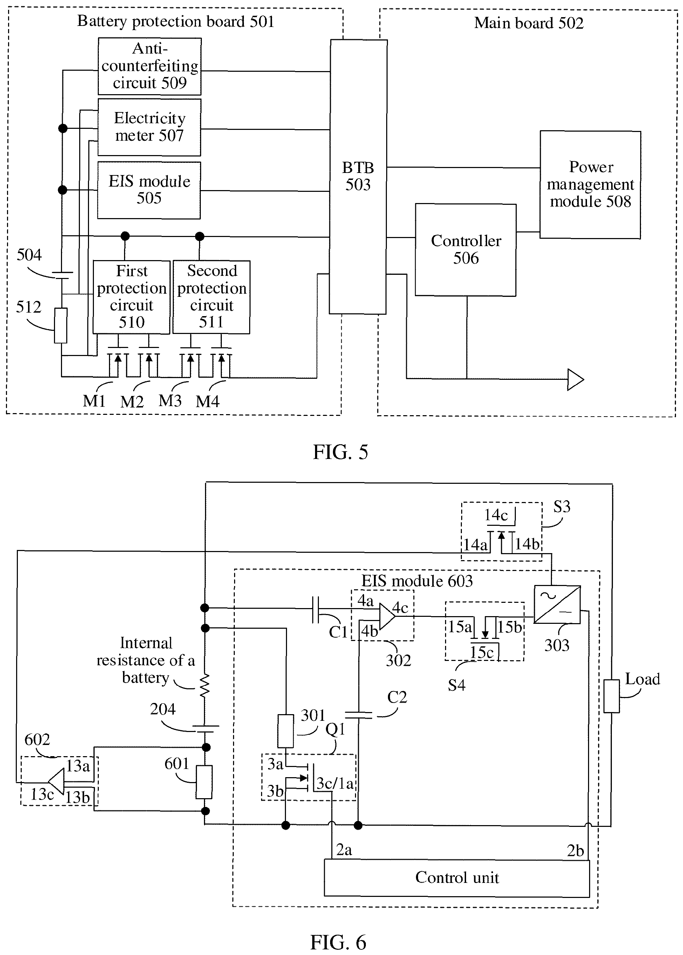

In this embodiment of this application, the electricity meter may be arranged on the main board (as shown in FIG. 2), or may be arranged on the battery protection board (as shown in FIG. 5). This is not limited herein.

For example, FIG. 5 is a schematic diagram of a connection relationship between a battery protection board and a main board according to an embodiment of this application. As shown in FIG. 5, the terminal device includes: a battery protection board 501, a main board 502, and a BTB 503. The battery protection board 501 and the main board 502 are connected by the BTB 503.

In FIG. 5, a battery 504, an EIS module 505, and an electricity meter 507 are arranged in the battery protection board 501. A controller 506 and a power management module 208 are arranged on the main board 502.

For structures and functions of the battery 504, the EIS module 505, the electricity meter 507, the controller 506, and the power management module 508, refer to the corresponding descriptions in FIG. 2 to FIG. 4B. Details are not described herein again.

The electricity meter 507 shown in FIG. 5 is located on a battery protection board side. The electricity meter 507 does not need to be connected to the battery by the BTB, so that a length of a lead connecting the electricity meter 507 to the battery can be reduced, impact of a voltage drop of the lead line and impact of the BTB on a parameter related to the battery are reduced, detection accuracy of the parameter related to the battery is improved, and accuracy of the parameter related to the battery is improved.

In some embodiments, the EIS module 505 and the electricity meter 507 may share a same sampling resistor. In this way, the resistor is reused, and a quantity of resistors on a battery protection board side can be reduced, to reduce space occupation and costs, and facilitate miniaturization of the terminal device.

In some embodiments, the EIS module 505 and the electricity meter 507 share a same analog to digital converter.

It may be understood that the EIS module needs to operate when a current output by the battery is relatively small or there is no current. When the current output by the battery is relatively small or there is no current, the EIS module uses the analog to digital converter. When the current is relatively large, the electricity meter performs electric quantity prediction by using the current flowing through the sampling resistor. When the current output by the battery is relatively large, the electricity meter uses the analog to digital converter.

In this embodiment of this application, when duration over which a current of the battery is less than a first threshold lasts for first duration, the EIS module operates through the analog to digital converter. When the current of the battery is greater than or equal to the first threshold, or the duration over which the current of the battery is less than the first threshold does not last for the first duration, the electricity meter uses the analog to digital converter.

In this way, the analog to digital converter is reused, a quantity of analog to digital converters in the circuit can be reduced, to reduce space occupation and costs, and facilitate miniaturization of the terminal device.

For example, FIG. 6 is a schematic diagram of structures of an EIS module 505 and an electricity meter 507 when sharing an analog to digital converter according to an embodiment of this application. As shown in FIG. 6, the circuit includes: the battery 204, a sampling resistor 601, a sixth differential amplifier 602, an EIS module 603, and a switch S3. The EIS module 603 includes a switch S4. The switch S4 is located between the first differential amplifier 302 and the analog to digital converter 303. A first electrode 15a of the switch S4 is connected to the output end 4c of the first differential amplifier 302, and a second electrode 15b of the switch S4 is connected to the analog to digital converter 303. A control electrode 15c of the switch S4 is controlled by the controller in the power supply circuit.

One end of the sampling resistor 601 is connected to the negative electrode of the battery 204, and the other end of the sampling resistor 601 is grounded. A first input end 13a of the sixth differential amplifier 602 is connected to one end of the sampling resistor 601, a second input end 13b of the sixth differential amplifier 602 is connected to the other end of the sampling resistor 601, an output end 13c of the sixth differential amplifier 602 is connected to a first electrode 14a of the switch S3, and a second electrode 14b of the switch S3 is connected to the analog to digital converter in the EIS module. A control electrode 14c of the switch S3 is controlled by the controller in the power supply circuit.

The sixth differential amplifier 602 is configured to determine a voltage signal of the sampling resistor 601 and transmit the voltage signal of the sampling resistor 601 to the analog to digital converter in the EIS module 603. The analog to digital converter may convert the voltage signal of the sampling resistor 601 into a digital signal used for representing the voltage signal of the sampling resistor 601. Subsequently, the electricity meter may determine a current of the battery based on the digital signal used for representing the voltage signal of the sampling resistor 601 and a resistance of the sampling resistor 601.

**In** this embodiment of this application, the switch S3 and the switch S4 may be single pole single throw switches or may be switch tubes.

The switch S3 and the switch S4 each may alternatively be replaced with another structure that can implement a same function, for example, a single pole double throw switch. Replacement structures of the switch S3 and the switch S4 are not specifically limited in this embodiment of this application.

An example in which both the switch S3 and the switch S4 are switch tubes is used. The controller is configured to: when duration over which a current of the battery is less than a first threshold does not last for first duration, or the current of the battery is greater than or equal to the first threshold, control the switch S3 to be turned on and the switch S4 to be turned off, so that the sixth differential amplifier 602 is connected to the analog to digital converter 303. In this way, the electricity meter may collect voltages at two ends of the sampling resistor 601 through the sixth differential amplifier 602, to obtain voltage signals of the sampling resistor 601.

The controller is configured to: when the duration over which the current of the battery is less than the first threshold lasts for the first duration, control the switch S3 to be turned off and the switch S4 to be turned on, so that the first differential amplifier 302 is connected to the analog to digital converter 303. In this way, the EIS module may collect voltages at two ends of the battery 204 through the first differential amplifier 302, to obtain voltage signals output by the battery 204.

In the embodiment shown in FIG. 6, the EIS module 603 is described by using the EIS module shown in FIG. 3B as an example. The EIS module 603 may alternatively be the EIS module shown in FIG. 3C, the EIS module shown in FIG. 4A, and the EIS module shown in FIG. 4B. A specific structure of the EIS module 603 is not limited in this embodiment of this application.

It may be understood that when the EIS module 603 is the EIS module shown in FIG. 3B, the switch S4 may be located between the switch S2 and the analog to digital converter 303, or may be located between the switch S1 and the analog to digital converter 303. The switch S4 and the switch S1 in FIG. 3B may be a same switch, the switch S4 and the switch S2 in FIG. 3B may be a same switch, and so on. A specific connection among the four switches, replacement structures of the four switches, or the like is not specifically limited in this embodiment of this application. The four switches are the switch S1, the switch S2, the switch S3, and the switch S4.

If the switch S4 and the switch S1 in FIG. 3B are the same switch, when the duration over which the current of the battery is less than the first threshold lasts for the first duration, and the switching frequency of Q1 is greater than the first value, the switch S4 is turned on, and both the switch S2 and the switch S3 are turned off, so that the voltages at the two ends of the battery 204 are collected through the first differential amplifier 302, to obtain the voltage signals output by the battery 204. When the duration over which the current of the battery is less than the first threshold lasts for the first duration, and the switching frequency of Q1 is less than or equal to the first value, the switch S2 is turned on, and both the switch S4 and the switch S3 are turned off, so that the voltages at the two ends of the battery 204 are collected through the fifth differential amplifier 304, to obtain the voltage signals output by the battery 204. When the duration over which the current of the battery is less than the first threshold does not last for the first duration, or the current of the battery is greater than or equal to the first threshold, the switch S3 is turned on, and both the switch S2 and the switch S4 are turned off, so that the voltages at the two ends of the sampling resistor 601 are collected through the sixth differential amplifier 302, to obtain the voltage signals of the sampling resistor 601. The switch S2, the switch S3, and the switch S4 each may alternatively be replaced with another structure that can implement a same function, for example, a single pole three throw switch. Replacement structures of the switch S2, the switch S3, and the switch S4 are not specifically limited in this embodiment of this application.

If the switch S4 and the switch S2 in FIG. 3B are the same switch, when the duration over which the current of the battery is less than the first threshold lasts for the first duration, and the switching frequency of Q1 is greater than the first value, the switch S1 is turned on, and both the switch S4 and the switch S3 are turned off, so that the voltages at the two ends of the battery 204 are collected through the first differential amplifier 302, to obtain the voltage signals output by the battery 204. When the duration over which the current of the battery is less than the first threshold lasts for the first duration, and the switching frequency of Q1 is less than or equal to the first value, the switch S4 is turned on, and both the switch S1 and the switch S3 are turned off, so that the voltages at the two ends of the battery 204 are collected through the fifth differential amplifier 304, to obtain the voltage signals output by the battery 204. When the duration over which the current of the battery is less than the first threshold does not last for the first duration, or the current of the battery is greater than or equal to the first threshold, the switch S3 is turned on, and both the switch S1 and the switch S4 are turned off, so that the voltages at the two ends of the sampling resistor 601 are collected through the sixth differential amplifier 302, to obtain the voltage signals of the sampling resistor 601. The switch S1, the switch S3, and the switch S4 each may alternatively be replaced with another structure that can implement a same function, for example, a single pole three throw switch. Replacement structures of the switch S1, the switch S3, and the switch S4 are not specifically limited in this embodiment of this application.

In some other embodiments, the EIS module 505 and the electricity meter 507 do not share an analog to digital converter. In this way, the EIS module 505 and the electricity meter 507 can better adapt to collection requirements of the EIS module 505 and the electricity meter 507 for different voltage signals.

Based on the foregoing embodiments, the battery protection board further includes: an anti-counterfeiting circuit, a first protection circuit, a second protection circuit, and the like. For example, as shown in FIG. 5, the battery protection board 501 further includes: an anti-counterfeiting circuit 509. One end of the anti-counterfeiting circuit 509 is connected to the power supply 504, and the other end of the anti-counterfeiting circuit 509 is connected to the BTB 503.

For a function of the anti-counterfeiting circuit 509, refer to the foregoing corresponding descriptions. Details are not described herein again.

As shown in FIG. 5, the battery protection board 501 includes: a first protection circuit 510 and a second protection circuit 511.

For structures and functions of the first protection circuit 510 and the second protection circuit 511, refer to the foregoing corresponding descriptions. Details are not described herein again.

In some embodiments, the first protection circuit and/or the second protection circuit detect/detects a voltage of the battery 204 and the like through a sampling resistor. For example, as shown in FIG. 5, a sampling resistor corresponding to the first protection circuit is a resistor 512.

In a first possible implementation, a sampling resistor corresponding to the EIS module 505 and the sampling resistor corresponding to the first protection circuit 510 are a same sampling resistor. In this way, the resistor is reused, and a quantity of resistors on a battery protection board side can be reduced, to reduce space occupation and costs, and facilitate miniaturization of the terminal device.

In a second possible implementation, a sampling resistor corresponding to the electricity meter 507 and the sampling resistor corresponding to the first protection circuit 510 are a same sampling resistor. In this way, the resistor is reused, and a quantity of resistors on a battery protection board side can be reduced, to reduce space occupation and costs, and facilitate miniaturization of the terminal device.

In a third possible implementation, a sampling resistor corresponding to the EIS module 505, a sampling resistor corresponding to the electricity meter 507, and the sampling resistor corresponding to the first protection circuit 510 are a same resistor. In this way, the resistor is reused, and a quantity of resistors on a battery protection board side can be reduced, to reduce space occupation and costs, and facilitate miniaturization of the terminal device.

It may be understood that, in the foregoing embodiments, the anti-counterfeiting circuit 509, the first protection circuit 510, the second protection circuit 511, the EIS module 505, and the electricity meter 507 may be independent modules, or may be a plurality of modules that are integrated together. For example, the anti-counterfeiting circuit 509, the first protection circuit 510, and the second protection circuit 511 are integrated on a same chip. Alternatively, the anti-counterfeiting circuit 509, the first protection circuit 510, the EIS module 505, and the electricity meter 507 are integrated on a same chip. In this way, an area occupied by the battery protection board can be reduced, and miniaturization of the terminal device is facilitated.

In addition, when the electricity meter 507 and the first protection circuit 510 are integrated on the same chip, a switch corresponding to the first protection circuit may be actively controlled to be turned on or turned off, to improve flexibility of a charging and discharging solution. A quantity and types of modules integrated on the same chip are not limited in this embodiment of this application.

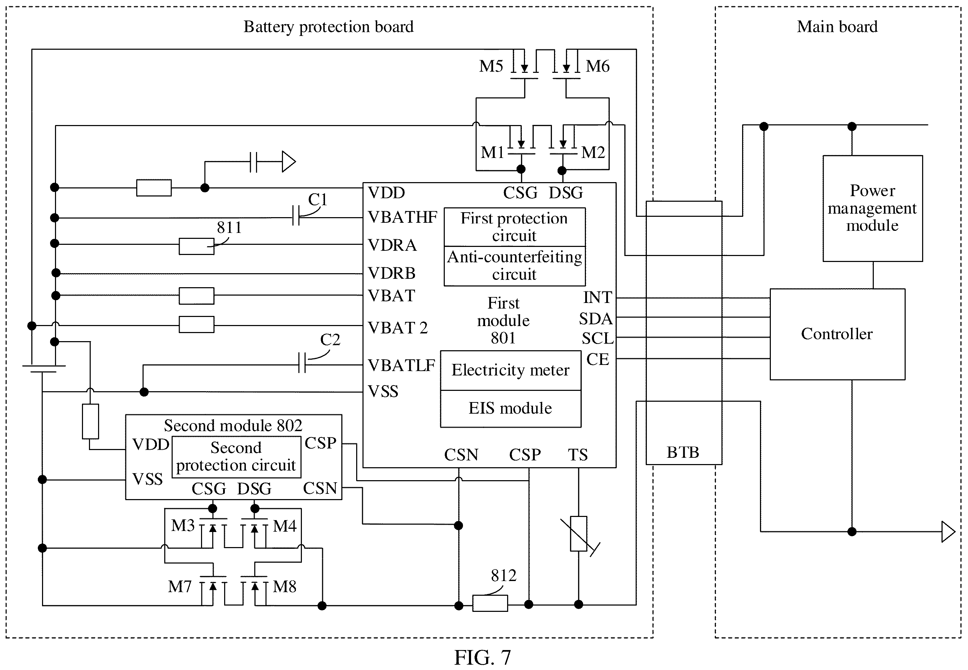

For example, an example in which the first protection circuit, the EIS module, and the electricity meter are integrated onto the same chip is used. FIG. 7 is a schematic diagram of a structure of a battery protection board according to an embodiment of this application. As shown in FIG. 7, the battery protection board includes: a first module 801 The first module 801 is integrated with the EIS module, the electricity meter, and the first protection circuit.

The first module 801 includes a plurality of pins. The plurality of pins include: a pin configured to connect to a resistor corresponding to the EIS, a pin configured to collect voltages of the battery, a pin configured to connect to the controller, and a pin configured to connect to the first switch M1 and/or the second switch M2.

For example, as shown in FIG. 7, the pin configured to connect to the resistor corresponding to the EIS includes: a VDRA pin, a CSN pin, and a CSP pin. The VDRA pin is connected to a resistor 811, the CSN pin is connected to one end of a resistor 812, and the CSP pin is connected to the other end of the resistor 812. The CSN pin and the CSP pin are configured to sample voltages at two ends of the resistor, so that the first module 801 determines a current flowing through the resistor 812, to facilitate subsequent calculation of the EIS. The resistor 811 may correspond to the foregoing resistor 301. The resistor 812 may correspond to the foregoing resistor 422.

The pin configured to collect the voltages of the battery includes: a VBATHF pin, a VBATLF pin, a VDRB pin, and a VSS pin. The VBATHF pin is connected to a capacitor C1, and the VBATLF pin is connected to a capacitor C2.

For functions of the capacitor C1 and the capacitor C2, refer to the foregoing corresponding descriptions. The VBATHF pin is configured to collect a voltage at the positive electrode of the battery. The VBATLF pin is configured to collect a voltage at the negative electrode of the battery. The VDRB pin is configured to collect the voltage at the positive electrode of the battery. The VSS pin is configured to collect the voltage at the negative electrode of the battery.

The pin configured to connect to the controller includes: an INT pin, an SDA pin, an SCL pin, and a CE pin. A third pin is configured to perform data communication. For example, the INT pin is configured to transmit an interruption signal, to notify the controller that there is data that needs to be processed. The SDA pin is configured to transmit a data signal. The SCL pin is configured to transmit a command and the like. The CE pin is configured to transmit a clock signal. The INT pin, the SDA pin, the SCL pin, the CE pin, and the like may form a communication interface.

The pin configured to connect to the first switch M1 and/or the second switch M2 includes: a CSG pin and a DSG pin. The CSG pin is configured to control the first switch M1 to be turned on or turned off, to implement a protection function of the first protection circuit. The DSG pin is configured to control the second switch M2 to be turned on or turned off, to implement the protection function of the first protection circuit.

In some embodiments, the battery protection board further includes a second module 802. The second module 802 includes a second protection circuit. The second module 802 includes a pin configured to connect the third switch M3 and/or the fourth switch M4.

In the foregoing embodiments, the first protection circuit may correspond to two switches, which are respectively the first switch M1 and the second switch M2. The first protection circuit may alternatively correspond to four switches, which are respectively the first switch M1, the second switch M2, a fifth switch M5, and a sixth switch M6. Similarly, in the foregoing embodiments, the second protection circuit may correspond to two switches, which are respectively the third switch M3 and the fourth switch M4. The second protection circuit may alternatively correspond to four switches, which are respectively the third switch M3, the fourth switch M4, a seventh switch M7, and an eighth switch M8. A specific quantity of switches corresponding to the protection circuit is not limited in this embodiment of this application.

It may be understood that the second protection circuit may alternatively be located in the first module 801. A specific position of the second protection circuit is not limited in this embodiment of this application. The first module 801 further includes a fifth pin configured to connect to the third switch M3 and/or the fourth switch M4.

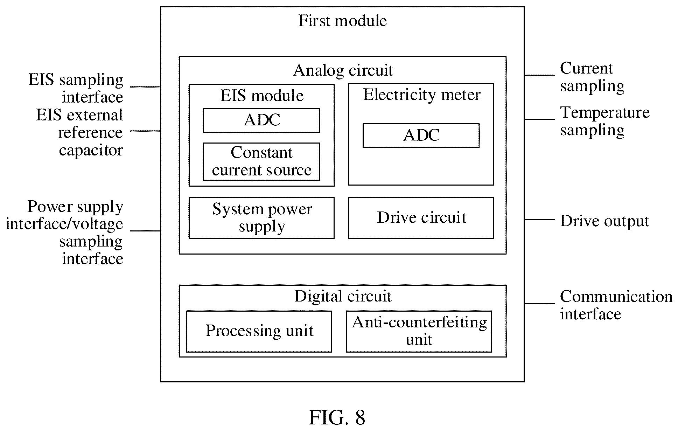

For example, FIG. 8 is a schematic diagram of a structure of a first module according to an embodiment of this application. As shown in FIG. 8, the first module includes: an analog circuit and a digital circuit. The analog circuit includes: an analog part of the EIS module, an analog circuit of the electricity meter, a system power supply, and a drive circuit. The digital part includes: a processing unit and an anti-counterfeiting unit.

The analog circuit of the EIS module includes, but is not limited to: a constant current source, an analog to digital converter of the EIS module, and the like. The analog to digital converter of the EIS module is configured to convert a tested analog signal into a digital signal, to facilitate subsequent processing by the processing unit.

The analog circuit of the electricity meter includes but is not limited to: an analog to digital converter of the electricity meter.

The system power supply is configured to supply power to the first module.

The drive circuit is configured to drive a switch corresponding to the protection circuit. For example, the drive circuit may be configured to drive a switch corresponding to the first protection circuit, for example, the first switch M1 and the second switch M2. The drive circuit may alternatively be configured to drive a switch corresponding to the second protection circuit, for example, the third switch M3 and the fourth switch M4.

The processing unit is configured to determine related parameters of the battery based on the digital signal transmitted by the analog circuit. The processing unit is further configured to communicate with a controller on a main board side, and transmit the related parameters such as a voltage, an internal resistance, a current, and a temperature of the battery to the controller, so that the controller subsequently determines parameters such as a charging parameter and a discharging parameter of the battery based on the related parameters of the battery.

For example, an EIS test is used as an example, the processing unit obtains, based on digital signals from the analog to digital converter of the EIS module, impedance values of the battery at different frequencies, and performs algorithm fitting processing on the impedance values of the battery at different frequencies, to obtain an internal resistance of the battery, so as to determine an aging degree of the battery.

The anti-counterfeiting unit is configured to store anti-counterfeiting information and/or battery-related information. The anti-counterfeiting information is used for indicating whether the battery is a genuine battery. The battery-related information includes: a battery type, a cell lifetime, a battery sequence number, and the like.

An embodiment of this application provides a terminal device. The terminal device includes: the power supply circuit.

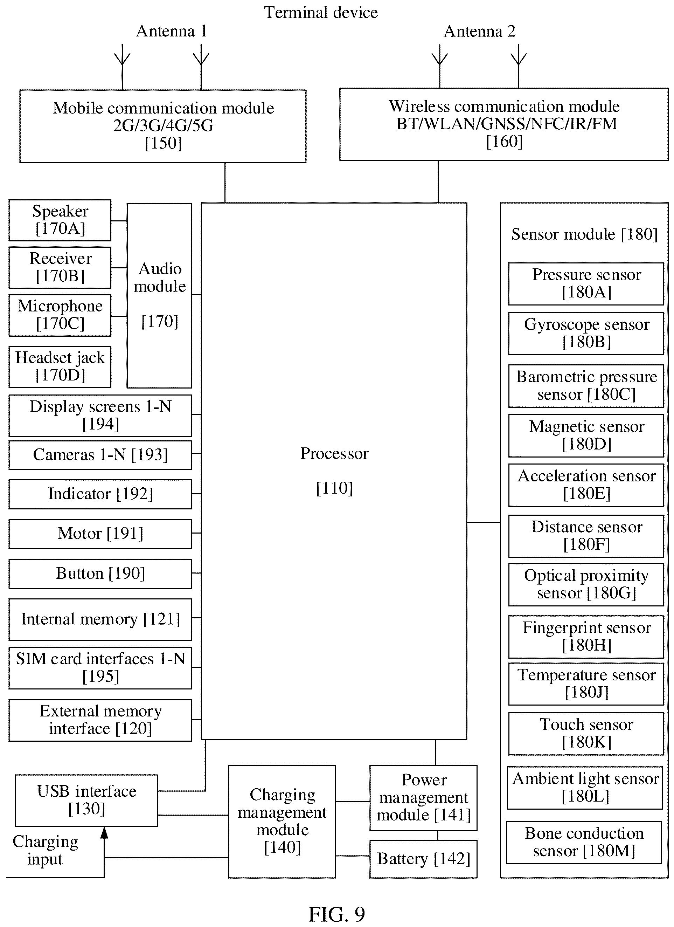

For example, FIG. 9 is a schematic diagram of a structure of a terminal device according to an embodiment of this application. As shown in FIG. 9, the terminal device includes: the terminal device may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display screen 194, a subscriber identification module (subscriber identification module, SIM) card interface 195, and the like. The sensor module 180 may include a pressure sensor 180A, a gyro sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, and a touch sensor 180K, an ambient light sensor 180L, a bone conduction sensor 180M, and the like.

It may be understood that the structure shown in this embodiment of the present invention does not constitute a specific limitation on the terminal device. In some other embodiments of this application, the terminal device may include more or fewer components than those shown in the figure, or combine some components, or split some components, or have different component arrangements. The components shown in the figure may be implemented by using hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

The controller may obtain a charging parameter, a discharging parameter, and the like of the battery according to the internal resistance of the battery. The controller may further send a control signal to the power management module. The control signal includes the charging parameter, the discharging parameter, and the like. For the charging parameter and the discharging parameter, refer to the foregoing corresponding descriptions. Details are not described herein again.

For a process in which the controller determines the charging parameter and the discharging parameter of the battery according to the internal resistance of the battery, refer to the foregoing corresponding descriptions. Details are not described herein again.

For a function of the power management module 141, refer to the corresponding descriptions in FIG. 2 to FIG. 8. Details are not described herein again.

In addition, in addition to the foregoing components, the device further runs an operating system, for example, an iOS operating system, an Android (android) operating system, or a Windows operating system. An application may be installed and run in the operating system.

A software system of the terminal device may use a hierarchical architecture, an event-driven architecture, a microcore architecture, a micro service architecture, or a cloud architecture, which are not described in detail herein again.

An embodiment of this application provides a chip. The chip includes the EIS module in the foregoing power supply circuit. For a structure and a function of the EIS module, refer to the foregoing corresponding descriptions. Details are not described herein again.

Optionally, the chip further includes one or more of the following: an electricity meter, a first protection circuit, a second protection circuit, and an anti-counterfeiting circuit. For structures and functions of the electricity meter, the first protection circuit, the second protection circuit, and the anti-counterfeiting circuit, refer to the foregoing corresponding descriptions. Details are not described herein again.

An embodiment of this application provides a chip. The chip includes a processor, and the processor is configured to invoke a computer program in a memory to execute the technical solutions of the controller in the foregoing embodiments. The implementation is similar to the foregoing related embodiments in terms of implementation principles and technical effects. Details are not described herein again.

An embodiment of this application further provides a computer-readable storage medium. The computer-readable storage medium stores a computer program. When the computer program is executed by a processor, the foregoing method performed by the controller is implemented. All or some of the methods described in the foregoing embodiments may be implemented by using software, hardware, firmware, or any combination thereof. If implemented in software, functions may be stored in a computer-readable medium or transmitted on a computer-readable medium as one or more instructions or code. The computer-readable medium may include a computer storage medium and a communication medium, and may further include any medium that enables a computer program to be transmitted from a place to another place. The storage medium may be any target medium accessible to a computer.

In a possible implementation, the computer-readable medium may include a RAM, a ROM, a compact disc read-only memory (compact disc read-only memory, CD-ROM) or another optical disk memory, a magnetic disk memory or another magnetic storage device, or any other medium that is to carry or store required program code in a form of an instruction or a data structure, and may be accessed by a computer. In addition, any connection is appropriately referred to as a computer-readable medium. For example, if software is transmitted from a website, a server or another remote source by using a coaxial cable, an optical fiber cable, a twisted pair, a digital subscriber line (Digital Subscriber Line, DSL) or wireless technologies (such as infrared ray, radio, and microwave), the coaxial cable, optical fiber cable, twisted pair, DSL or wireless technologies such as infrared ray, radio, and microwave are included in the definition of the medium. A magnetic disk and an optical disc used herein include an optical disc, a laser disc, an optical disc, a digital versatile disc (Digital Versatile Disc, DVD), a floppy disk, and a blue ray disc, where the magnetic disk generally reproduces data in a magnetic manner, and the optical disc reproduces data optically by using laser. A combination of the foregoing should also be included in the scope of the computer-readable medium.

An embodiment of this application provides a computer program product. The computer program product includes a computer program, and when the computer program is run, a computer is enabled to perform the foregoing method performed by the controller.

The embodiments of this application are described with reference to flowcharts and/or block diagrams of the method, the device (system), and the computer program product according to the embodiments of this application. It should be understood that computer program instructions can implement each procedure and/or block in the flowcharts and/or block diagrams and a combination of procedures and/or blocks in the flowcharts and/or block diagrams. These computer program instructions may be provided to a general-purpose computer, a special-purpose computer, an embedded processor, or a processing unit of another programmable device to generate a machine, so that the instructions executed by the computer or the processing unit of the another programmable data processing device generate an apparatus for implementing a specific function in one or more flows in the flowcharts and/or in one or more blocks in the block diagrams.

It should be noted that user information (including but not limited to user equipment information, user personal information, and the like) and data (including but not limited to data used for analysis, stored data, displayed data, and the like) involved in this application are all information and data that are authorized by the user or that are fully authorized by each party. In addition, collection, use, and processing of the related data need to comply with relevant laws, regulations, and standards, and a corresponding operation entry is provided for the user to choose to authorize or reject.

The objectives, technical solutions, and beneficial effects of the present invention are further described in detail in the foregoing specific implementations. It should be understood that the foregoing descriptions are merely specific implementations of the present invention, but are not intended to limit the protection scope of the present invention. Any modification, equivalent replacement, or improvement made based on the technical solutions in the present invention shall fall within the protection scope of the present invention.

## Claims

1. A power supply circuit, comprising: an EIS module, a controller, and a power management module, wherein
the EIS module is connected to the controller, the controller is connected to the power management module, and the EIS module is further configured to connect to a battery;
the EIS module is configured to detect an internal resistance of the battery;
the controller is configured to obtain a charge cutoff voltage and/or a charge cutoff current of the battery according to the internal resistance of the battery, and send a first control signal to the power management module, wherein the first control signal comprises the charge cutoff voltage and/or the charge cutoff current; and
the power management module is configured to control the charge cutoff voltage and/or the charge cutoff current of the battery according to the first control signal.

2. The circuit according to claim 1, wherein the EIS module comprises: a detection unit and a control unit, wherein
an input end of the detection unit is connected to a first end of the control unit, and an output end of the detection unit is connected to a second end of the control unit;
the control unit is configured to control, through the first end, the detection unit to output a plurality of disturbance signals to the battery, wherein frequencies of the plurality of disturbance signals are different;
the detection unit is configured to detect a plurality of voltage signals output by the battery under the plurality of disturbance signals, and convert the plurality of voltage signals into a plurality of digital signals; and
the control unit is further configured to obtain the plurality of digital signals through the second end, and obtain the internal resistance of the battery based on the plurality of digital signals.

3. The circuit according to claim 2, wherein
the disturbance signal comprises: a square wave or a quasi-square wave.

4. The circuit according to claim 3, wherein the detection unit comprises: a first resistor, a switch tube Q1, a first differential amplifier, and an analog to digital converter;
one end of the first resistor is connected to a positive electrode of the battery, the other end of the first resistor is connected to a first electrode of the switch tube Q1, and a second electrode of the switch tube Q1 is grounded; a first input end of the first differential amplifier is connected to the positive electrode of the battery, a second input end of the first differential amplifier is connected to a negative electrode of the battery, and an output end of the first differential amplifier is connected to an input end of the analog to digital converter;
the input end of the detection unit is a control electrode of the switch tube Q1; the output end of the detection unit is an output end of the analog to digital converter;
the control unit is specifically configured to control, through the first end, the switch tube Q1 to be turned on or turned off, to control the detection unit to output the plurality of disturbance signals to the battery;
the first differential amplifier is configured to amplify a difference between a voltage at the positive electrode of the battery and a voltage at the negative electrode of the battery based on a first amplification coefficient;
the analog to digital converter is configured to convert a plurality of voltage signals output by the first differential amplifier into the plurality of digital signals, and transmit the plurality of digital signals to the control unit; and
the control unit is specifically configured to obtain the internal resistance of the battery based on the plurality of digital signals.

5. The circuit according to claim 4, wherein
the control unit is specifically configured to control, through the first end, the switch tube Q1 to be turned on or turned off according to a duty cycle of 50%.

6. The circuit according to claim 4 or 5, wherein
the control unit is specifically configured to perform Fourier transform on the plurality of digital signals, to obtain voltage values corresponding to a plurality of frequencies;
the control unit is further configured to calculate ratios of the voltage values corresponding to the plurality of frequencies to a value of a current flowing through the first resistor, to obtain impedances of the battery at the plurality of frequencies; and
the control unit is further configured to perform fitting processing on the impedances of the battery at the plurality of frequencies, to obtain the internal resistance of the battery.

7. The circuit according to any one of claims 4 to 6, wherein the detection unit further comprises: a constant current source;
the constant current source is connected between the first resistor and the battery, or the constant current source is connected between the first resistor and the switch tube Q1; and
the constant current source is configured to stabilize the current flowing through the first resistor.

8. The circuit according to claim 7, wherein the constant current source comprises: a second differential amplifier, a second resistor, and a switch tube Q2;
the constant current source is connected between the first resistor and the battery, a first electrode of the switch tube Q2 is connected to the positive electrode of the battery, a second electrode of the switch tube Q2 is connected to one end of the first resistor, a control electrode of the switch tube Q2 is connected to an output end of the second differential amplifier, and a first input end of the second differential amplifier is configured to input a first reference voltage; and a second input end of the second differential amplifier is connected to the other end of the second resistor, and one end of the second resistor is connected to the second electrode of the switch tube Q2; or
the constant current source is connected between the first resistor and the switch tube Q1, a first electrode of the switch tube Q2 is connected to the other end of the first resistor, a second electrode of the switch tube Q2 is connected to the first electrode of the switch tube Q1, a control electrode of the switch tube Q2 is connected to an output end of the second differential amplifier, and a first input end of the second differential amplifier is configured to input a first reference voltage; and a second input end of the second differential amplifier is connected to the other end of the second resistor, and one end of the second resistor is connected to the second electrode of the switch tube Q2; and
the second differential amplifier is configured to adjust a voltage at the control electrode of the switch tube Q2 based on a voltage at the other end of the second resistor and the first reference voltage, to stabilize a voltage at one end of the second resistor.

9. The circuit according to claim 7, wherein the constant current source comprises: a switch tube Q3, a third differential amplifier, a third resistor, a fourth differential amplifier, and a fourth resistor;
when the constant current source is located between the first resistor and the battery, a first electrode of the switch tube Q3 is connected to the positive electrode of the battery, a second electrode of the switch tube Q3 is connected to one end of the third resistor, and a control electrode of the switch tube Q3 is connected to an output end of the third differential amplifier; the other end of the third resistor is connected to one end of the first resistor; a first input end of the third differential amplifier is configured to input a second reference voltage; a second input end of the third differential amplifier is connected to one end of the fourth resistor; the other end of the fourth resistor is connected to an output end of the fourth differential amplifier; and one end of the third resistor is connected to a first input end of the fourth differential amplifier, and the other end of the third resistor is connected to a second input end of the fourth differential amplifier; or
when the constant current source is located between the first resistor and the switch tube Q1, a first electrode of the switch tube Q3 is connected to the other end of the first resistor, a second electrode of the switch tube Q3 is connected to one end of the third resistor, and a control electrode of the switch tube Q3 is connected to an output end of the third differential amplifier; the other end of the third resistor is connected to the first electrode of the switch tube Q1; a first input end of the third differential amplifier is configured to input a second reference voltage; a second input end of the third differential amplifier is connected to one end of the fourth resistor; the other end of the fourth resistor is connected to an output end of the fourth differential amplifier; and one end of the third resistor is connected to a first input end of the fourth differential amplifier, and the other end of the third resistor is connected to a second input end of the fourth differential amplifier;
the fourth differential amplifier is configured to output a voltage based on a voltage difference between two ends of the third resistor, wherein the voltage output by the fourth differential amplifier is directly proportional to the voltage difference between the two ends of the third resistor; and
the third differential amplifier is configured to adjust a voltage at the control electrode of the switch tube Q3 based on the second reference voltage and a voltage at one end of the fourth resistor, to stabilize the voltage difference between the two ends of the third resistor.

10. The circuit according to any one of claims 4 to 9, wherein the detection unit further comprises: a capacitor C1 and/or a capacitor C2;
one end of the capacitor C1 is connected to the positive electrode of the battery, and the other end of the capacitor C1 is connected to the first input end of the first differential amplifier; one end of the capacitor C2 is connected to the negative electrode of the battery, and the other end of the capacitor C1 is connected to the second input end of the first differential amplifier;
the capacitor C1 is configured to filter out a direct current component of a voltage input to the first input end of the first differential amplifier; and
the capacitor C2 is configured to filter out a direct current component of a voltage input to the second input end of the first differential amplifier.

11. The circuit according to claim 10, wherein the detection unit further comprises: a first switch unit and a fifth differential amplifier;
a first input end of the first switch unit is connected to the output end of the first differential amplifier; a second input end of the first switch unit is connected to an output end of the fifth differential amplifier; an output end of the first switch unit is connected to the analog to digital converter; a first input end of the fifth differential amplifier is connected to the positive electrode of the battery, and a second input end of the fifth differential amplifier is connected to the negative electrode of the battery;
the control unit is specifically configured to: when a switching frequency of the switch tube Q1 is greater than a first value, control the first input end of the first switch unit to be connected to the output end of the first switch unit, so that the first differential amplifier is connected to the analog to digital converter; and
the control unit is specifically configured to: when the switching frequency of the switch tube Q1 is less than or equal to the first value, control the second input end of the first switch unit to be connected to the output end of the first switch unit, so that the fifth differential amplifier is connected to the analog to digital converter.

12. The circuit according to claim 11, wherein the detection unit further comprises: the first switch unit comprises: a switch S1 and a switch S2;
a first electrode of the switch S1 is connected to the output end of the first differential amplifier, a second electrode of the switch S1 is connected to the analog to digital converter, and a control electrode of the switch S1 is controlled by the control unit; a first electrode of the switch S2 is connected to the output end of the fifth differential amplifier, a second electrode of the switch S2 is connected to the analog to digital converter, and a control electrode of the switch S2 is controlled by the control unit;
the control unit is specifically configured to: when the switching frequency of the switch tube Q1 is greater than the first value, control the switch S1 to be turned on and the switch S2 to be turned off, so that the first differential amplifier is connected to the analog to digital converter; and
the control unit is further specifically configured to: when the switching frequency of the switch tube Q1 is less than or equal to the first value, control the switch S1 to be turned off and the switch S2 to be turned on, so that the fifth differential amplifier is connected to the analog to digital converter.

13. The circuit according to any one of claims 1 to 12, wherein
the controller is further configured to obtain a discharge cutoff voltage and/or a discharge cutoff current of the battery based on the internal resistance of the battery, and send a second control signal to the power management module, wherein the second control signal further comprises: the discharge cutoff voltage and/or the discharge cutoff current; and
the power management module is further configured to control the discharge cutoff voltage and/or the discharge cutoff current of the battery according to the second control signal.

14. The circuit according to any one of claims 1 to 13, wherein the circuit further comprises: an electricity meter; the electricity meter is connected to the controller;
the electricity meter is configured to detect a current of the battery and transmit the current of the battery to the controller; and
the controller is configured to: when duration over which the current of the battery is less than a first threshold lasts for first duration, control the EIS module to detect the internal resistance of the battery.

15. The circuit according to claim 14, wherein the electricity meter comprises: a fifth resistor and a sixth differential amplifier; the circuit further comprises: a second switch unit; the EIS module comprises: a first differential amplifier and an analog to digital converter;
one end of the fifth resistor is connected to the negative electrode of the battery, the other end of the fifth resistor is grounded, a first input end of the sixth differential amplifier is connected to one end of the fifth resistor, a second input end of the sixth differential amplifier is connected to the other end of the fifth resistor, and an output end of the sixth differential amplifier is connected to a first input end of the second switch unit; a second input end of the second switch unit is connected to an output end of the first differential amplifier, and an output end of the second switch unit is connected to the analog to digital converter; the second switch unit is controlled by the controller;
the electricity meter is configured to obtain the current of the battery based on a voltage signal of the fifth resistor that is determined by the sixth differential amplifier and a resistance of the fifth resistor;
the controller is further configured to: when the duration over which the current of the battery is less than the first threshold lasts for the first duration, control the first input end of the second switch unit to be connected to the output end of the second switch unit, so that the first differential amplifier is connected to the analog to digital converter; and
the controller is further configured to: when the current of the battery is greater than or equal to the first threshold, control the second input end of the second switch unit to be connected to the output end of the second switch unit, so that the sixth differential amplifier is connected to the analog to digital converter.

16. The circuit according to any one of claims 1 to 15, wherein the circuit further comprises: a first protection circuit, a second protection circuit, a first switch M1, a second switch M2, a third switch M3, and a fourth switch M4;
a first detection end of the first protection circuit is connected to the positive electrode of the battery, a first control end of the first protection circuit is connected to a control end of the first switch M1, a second control end of the first protection circuit is connected to a control end of the second switch M2, a first detection end of the second protection circuit is connected to the positive electrode of the battery, a first control end of the second protection circuit is connected to a control end of the third switch M3, and a second control end of the second protection circuit is connected to a control end of the fourth switch M4;
one connection end of the first switch M1 is connected to the negative electrode of the battery, the other connection end of the first switch M1 is connected to one connection end of the second switch M2, the other connection end of the second switch M2 is connected to one connection end of the third switch M3, the other connection end of the third switch M3 is connected to one connection end of the fourth switch M4, and the other connection end of the fourth switch M4 is connected to the negative electrode of the battery;
the first protection circuit is configured to, when detecting that the battery has a phenomenon of overvoltage, undervoltage, and/or overcurrent, control the first switch M1 and/or the second switch M2 to be turned off, to disconnect the battery from a load; and
the second protection circuit is configured to: when detecting that the battery has the phenomenon of overvoltage, undervoltage, and/or overcurrent, control the third switch M3 and/or the fourth switch M4 to be turned off, to disconnect the battery from the load.

17. A chip, comprising the EIS module according to any one of claims 1 to 16.

18. The chip according to claim 17, wherein the chip further comprises one or more of the following modules: an electricity meter, a first protection circuit, and a second protection circuit.

19. A terminal device, comprising the power supply circuit according to any one of claims 1 to 16.
